# EUROPEAN PATENT APPLICATION

(11) **EP 4 682 937 A1**
(43) Date of publication of application: **21.01.2026**
(21) Application number: 24770641.9
(22) Date of filing: 05.03.2024
(51) Int. Cl.: H01L 21/02, B25J 13/00, G05B 19/418, H01L 21/205, H01L 21/3065, H01L 21/677

(54) **MAINTENANCE WORK ASSISTANCE SYSTEM, CONTROL METHOD, AND CONTROL PROGRAM**

(30) Priority: 16.03.2023 JP 2023041601
(71) Applicant: Tokyo Electron Limited, Tokyo 107-6325 (JP)
(72) Inventor: KIM, Hyejin, Tokyo 107-6325 (JP); IKEDA, Gaku, Fuchu City, Tokyo 183-8705 (JP); SHINDO, Takehiro, Nirasaki City, Yamanashi 407-0192 (JP); MORIYA, Tsuyoshi, Tokyo 107-6325 (JP); MORI, Takuya, Tokyo 107-6325 (JP); TERUUCHI, Satoru, Kurokawa-gun, Miyagi 981-3629 (JP)
(74) Representative: Hoffmann Eitle
(86) International application number: PCT/JP2024/008252
(87) International publication number: WO 2024/190531

(57) **Abstract**

To ensure consistency in quality of maintenance work, a maintenance work support system including a work robot for performing maintenance work for each work item includes: a measurement unit configured to measure a measurement-target part specified for a target work item every time maintenance work for the work item is performed; a determination unit configured to determine whether or not a measurement result measured by the measurement unit satisfies a work quality set for the work item; and a control unit configured to, when it is determined that the work quality is not satisfied, control an additional operation for the maintenance work for the work item to be performed until the determination unit determines that the work quality is satisfied.

## Description

### TECHNICAL FIELD

The present disclosure relates to a maintenance work support system, a control method, and a control program.

### BACKGROUND ART

Maintenance work in a substrate processing system, such as replacement of consumables, cleaning, and the like, is generally performed by workers manually. In the meantime, manual work performed by workers can result in variations in the work quality. Therefore, introduction of a robot configured to support the maintenance work of the workers is being considered.

### CITATION LIST

### PATENT LITERATURE

PTL 1: Japanese Patent Application Laid-Open Publication No. 2021-136359
PTL 2: International Publication No. WO 2021/220752
PTL 3: International Publication No. WO 2021/220753

### SUMMARY OF THE INVENTION

### TECHNICAL PROBLEM

The present disclosure provides a maintenance work support system configured to ensure consistency in quality of maintenance work, a control method, and a control program.

### SOLUTION TO THE PROBLEM

A maintenance work support system according to one embodiment of the present disclosure has, for example, the following configuration. That is, the maintenance work support system, including a work robot configured to perform maintenance work for each work item, includes:
a measurement unit configured to measure a measurement-target part specified for a target work item every time maintenance work for the work item is performed;
a determination unit configured to determine whether or not a measurement result measured by the measurement unit satisfies a work quality set for the work item; and
a control unit configured to, when it is determined that the work quality is not satisfied, control an additional operation for the maintenance work for the work item to be performed until the determination unit determines that the work quality is satisfied.

### ADVANTAGEOUS EFFECTS OF THE INVENTION

According to the present disclosure, it is possible to ensure consistency in quality of maintenance work.

### BRIEF DESCRIPTION OF THE DRAWINGS

[FIG. 1] FIG. 1 is a diagram showing an application example of a maintenance work support system.
[FIG. 2] FIG. 2 is a diagram showing an example of a system configuration of a maintenance work support system.
[FIG. 3] FIG. 3 is a diagram showing an example of work items of maintenance work and state measurement.
[FIG. 4] FIG. 4 is a view showing an example of an etching processing system, which is a target system of maintenance work.
[FIG. 5] FIG. 5 is a view showing an example of an etching apparatus, which is a target apparatus of maintenance work.
[FIG. 6] FIG. 6 is a diagram showing an example of work quality measurement items for maintenance work for an etching apparatus.
[FIG. 7A] FIG. 7A is a view showing an example of a work robot.
[FIG. 7B] FIG. 7B is a view showing an example of a stowable work robot.
[FIG. 8A] FIG. 8A is a first view showing an operation example of a work robot.
[FIG. 8B] FIG. 8B is a second view showing an operation example of a work robot.
[FIG. 9A] FIG. 9A is a first view showing an operation example of a stowable work robot.
[FIG. 9B] FIG. 9B is a second view showing an operation example of a stowable work robot.
[FIG. 9C] FIG. 9C is a third view showing an operation example of a stowable work robot.
[FIG. 10] FIG. 10 is a diagram showing an example of a hardware configuration of a controller included in a work robot and a stowable work robot.
[FIG. 11A] FIG. 11A is a diagram showing an example of a functional configuration of a controller included in a work robot in a first travelling phase.
[FIG. 11B] FIG. 11B is a diagram showing an example of a functional configuration of a controller included in a stowable work robot in a second travelling phase.
[FIG. 11C] FIG. 11C is a diagram showing an example of a functional configuration of a controller included in a work robot and a stowable work robot in a work phase.
[FIG. 12] FIG. 12 is a diagram showing a specific example of stored work quality information.
[FIG. 13] FIG. 13 is a diagram explaining details of a work quality training unit.
[FIG. 14] FIG. 14 is a diagram explaining details of a work parameter optimization unit.
[FIG. 15] FIG. 15 is a diagram showing a specific example of processing of a work information collection unit.
[FIG. 16] FIG. 16 is a flowchart showing a flow of a maintenance work support processing performed by a work robot and a stowable work robot.
[FIG. 17A] FIG. 17A is a view showing an example of a conveying robot.
[FIG. 17B] FIG. 17B is a view showing an example of an operation of a conveying robot.
[FIG. 18] FIG. 18 is a diagram showing a specific example of parts provided by a conveying robot.
[FIG. 19] FIG. 19 is a diagram showing an example of a hardware configuration of a controller included in a conveying robot.
[FIG. 20] FIG. 20 is a diagram showing an example of a functional configuration of a controller included in a conveying robot.
[FIG. 21A] FIG. 21A is a first diagram showing a specific example of processing performed by a cooperative control unit.
[FIG. 21B] FIG. 21B is a second diagram showing a specific example of processing performed by a cooperative control unit.
[FIG. 22] FIG. 22 is a flowchart showing a flow of a maintenance work support processing performed by a conveying robot.
[FIG. 23] FIG. 23 is a diagram showing an example of a remote monitoring apparatus.
[FIG. 24] FIG. 24 is a diagram showing an example of a hardware configuration of a remote monitoring apparatus.
[FIG. 25] FIG. 25 is a diagram explaining details of a maintenance work management unit.
[FIG. 26] FIG. 26 is a diagram explaining details of a substrate quality training unit.
[FIG. 27] FIG. 27 is a diagram explaining details of a work information optimization unit.
[FIG. 28A] FIG. 28A is a first flowchart showing a flow of a maintenance work support processing performed by a remote monitoring apparatus.
[FIG. 28B] FIG. 28B is a second flowchart showing a flow of a maintenance work support processing performed by a remote monitoring apparatus.

### DETAILED DESCRIPTION OF THE INVENTION

Each embodiment will be described below with reference to the attached drawings. In the present specification and drawings, components having substantially the same functional configurations will be denoted by the same reference numerals, and duplicate descriptions thereof will be omitted.

### [First Embodiment]

### <Application Example of Maintenance Work Support System>

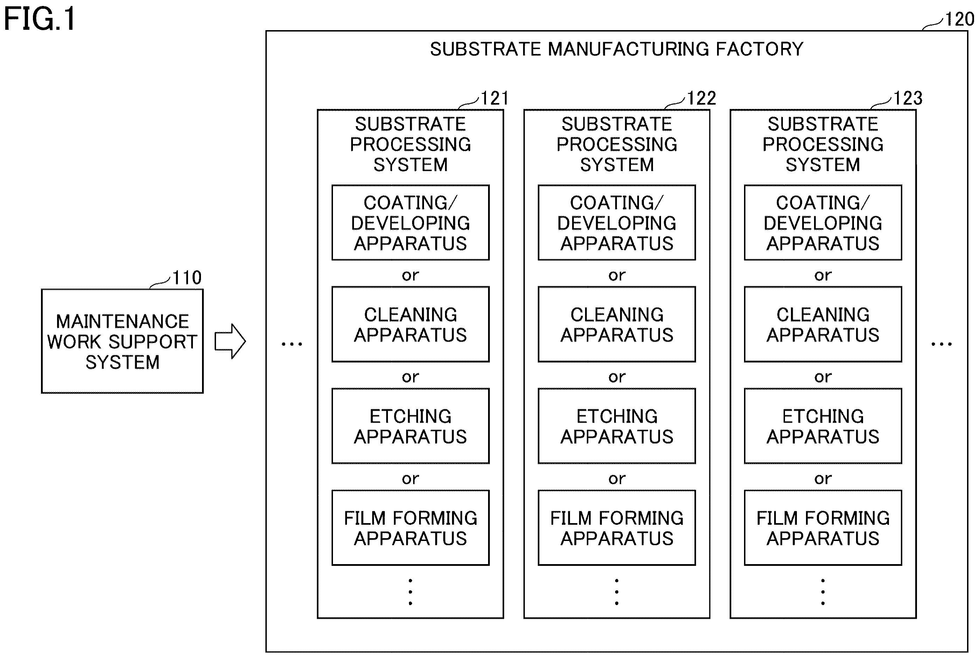

First, an application example of a maintenance work support system according to a first embodiment will be described. FIG. 1 is a diagram showing an application example of a maintenance work support system. As shown in FIG. 1, a maintenance work support system 110 according to the first embodiment is applied to, for example, a substrate manufacturing factory 120 equipped with a plurality of substrate processing systems, and is configured to support maintenance work for substrate processing systems 121 to 123, which are target systems.

The example shown in FIG. 1 shows a case where the substrate manufacturing factory 120 includes at least three substrate processing systems 121 to 123. However, the number of substrate processing systems included in the substrate manufacturing factory 120 is not limited to three. The substrate processing systems here include at least one of a coating/developing apparatus, a cleaning apparatus, an etching apparatus, or a film forming apparatus, but may also include any apparatuses other than these apparatuses.

Further, although only the substrate processing systems are shown in the example of FIG. 1, the substrate manufacturing factory 120 may include apparatuses (for example, a substrate quality inspection apparatus, and the like) that do not belong to a substrate processing system.

In the substrate manufacturing factory 120, the maintenance work support system 110 may be configured to perform all maintenance work to which the substrate processing systems 121 to 123, which are the target systems, should be subjected. Alternatively, it may be configured to perform part of the maintenance work to which the substrate processing systems 121 to 123, which are the target systems, should be subjected. In other words, the maintenance work support system 110 may be configured to perform the maintenance work for the substrate processing systems 121 to 123, which are the target systems, in cooperation with workers. Alternatively, the maintenance work support system 110 may be configured to assist in the maintenance work that is performed by workers on the substrate processing systems 121 to 123 which are the target systems.

### <System Configuration of Maintenance Work Support System>

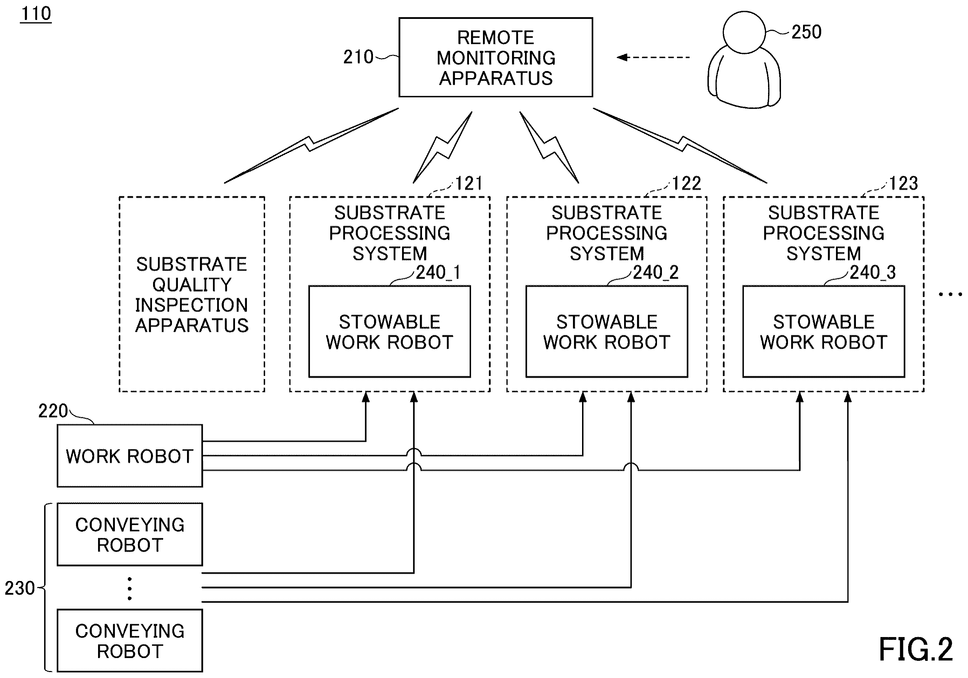

Next, the system configuration of the maintenance work support system according to the first embodiment will be described. FIG. 2 is a diagram showing an example of the system configuration of the maintenance work support system.

As shown in FIG. 2, the maintenance work support system 110 includes a remote monitoring apparatus 210, a work robot 220, conveying robots 230, and stowable work robots 240_1 to 240_3.

The remote monitoring apparatus 210 is an example of a management apparatus, and is communicably connected to each apparatus (in the example of FIG. 2, the substrate processing systems 121 to 123, and the substrate quality inspection apparatus) included in the substrate manufacturing factory 120. The remote monitoring apparatus 210 is communicably connected to respective robots (in the example of FIG. 2, the work robot 220, the conveying robots 230, and the stowable work robots 240_1 to 240_3) that are constituents of the maintenance work support system 110.

The remote monitoring apparatus 210 transmits a state measurement instruction to the stowable work robots 240_1 to 240_3 to instruct them to measure the states of the interiors of the substrate processing systems 121 to 123 during a substrate processing period in which substrate processing is performed by the substrate processing systems 121 to 123. The remote monitoring apparatus 210 determines the maintenance schedules for the substrate processing systems 121 to 123 based on state measurement results (the results of measuring the states of the interiors of the substrate processing systems 121 to 123) transmitted from the stowable work robots 240_1 to 240_3.

On the other hand, after entering a maintenance period, the remote monitoring apparatus 210 transmits a maintenance work instruction to the work robot 220, the stowable work robots 240_1 to 240_3, and the conveying robots 230. The remote monitoring apparatus 210 is capable of being operated by a remote monitoring person 250 so as to remotely operate the work robot 220 and the stowable work robots 240_1 to 240_3 when any failure occurs in any of the robots during their maintenance work.

Furthermore, the remote monitoring apparatus 210 receives work information from the work robot 220 and the stowable work robots 240_1 to 240_3 after the maintenance work is completed, and also receives information on the substrate qualities of processed substrates from the substrate quality inspection apparatus at a start-up. In this way, the remote monitoring apparatus 210 optimizes the work information regarding the maintenance work, so as for the work information present in the work robot 220 and the stowable work robots 240_1 to 240_3 to be updated with the optimized work information.

The work robot 220 is an example of a first work robot. The work robot 220 receives a maintenance work instruction from the remote monitoring apparatus 210. The work robot 220 performs maintenance work for a work item identified based on the received maintenance work instruction for a target system (any of the substrate processing systems 121 to 123) identified likewise. The work robot 220 gains access to the substrate processing systems 121 to 123 from outside and performs the maintenance work on the interiors of the substrate processing systems 121 to 123 through openings provided in the processing apparatuses of the substrate processing systems 121 to 123. Alternatively, as the maintenance work, the work robot 220 performs unit-by-unit-based replacement, instead of gaining access to the substrate processing systems 121 to 123 from outside and performing the maintenance work on the interiors of the substrate processing systems 121 to 123.

The work robot 220 receives necessary parts for performing the maintenance work on the interiors of the substrate processing systems 121 to 123, or for instead performing unit-by-unit-based replacement as the maintenance work, from the conveying robots 230. The work robot 220 passes any parts that have become unnecessary as a result of performing the maintenance work on the interiors of the substrate processing systems 121 to 123 or instead performing unit-by-unit-based replacement as the maintenance work, to the conveying robots 230.

In addition, the work robot 220 checks the work quality during maintenance work and continues its operation until a predetermined criterion is satisfied. For example, when determining that the work quality has deteriorated due to aging or the like, the work robot 220 optimizes work parameters (operation amount, number of times to perform an operation, and the like) related to each operation involved in the maintenance work.

After completion of the maintenance work, the work robot 220 transmits performed work information regarding the work performed (the content of the operation of each work item) to the remote monitoring apparatus 210. Furthermore, upon receiving work information for update from the remote monitoring apparatus 210, the work robot 220 updates the work information.

The conveying robots 230 receive a maintenance work instruction from the remote monitoring apparatus 210. The conveying robots 230 convey parts necessary for the work robot 220 to perform maintenance work for a work item identified based on the received maintenance work instruction for a target system that is identified likewise. Specifically, the conveying robots 230 identify parts necessary for the maintenance work of the identified work item, are mounted with the identified parts at a specific storage location, and convey them to the position of the target system.

In addition, the conveying robots 230 receive parts that have become unnecessary as a result of the maintenance work being performed by the work robot 220 from the work robot 220 and convey them to a specific disposal location. In the specific disposal location, disposal of the parts that have become unnecessary as a result of the maintenance work being performed, replacement or cleaning of used end effectors, and the like are performed.

These conveying operations by the conveying robots 230 are efficiently performed based on a cooperative control being performed with the work robot 220.

The stowable work robots 240_1 to 240_3 are an example of a second work robot. Each of the stowable work robots 240_1 to 240_3 is housed inside the substrate processing systems 121 to 123. Upon receiving a state measurement instruction from the remote monitoring apparatus 210, the stowable work robots 240_1 to 240_3 measure the state of the interiors of the substrate processing systems 121 to 123 and transmit state measurement results (for example, the degree of deterioration of consumables, the degree of contamination on inner walls, and the like) to the remote monitoring apparatus 210. Thus, the remote monitoring apparatus 210 can determine the maintenance schedules for the substrate processing systems 121 to 123 based on the state measurement results.

The stowable work robots 240_1 to 240_3 receive a maintenance work instruction from the remote monitoring apparatus 210. The stowable work robots 240_1 to 240_3 perform maintenance work for the work items identified from the received maintenance work instruction.

In addition, the stowable work robots 240_1 to 240_3 check the work quality during maintenance work, and continue their operations until a predetermined criterion is satisfied. However, in a case where the predetermined criterion remains unsatisfied even when the operations are continued, the stowable work robots 240_1 to 240_3 perform other processing such as, for example, outputting an alarm, and the like. Note that, for example, when determining that that the work quality has deteriorated due to aging or the like, the stowable work robots 240_1 to 240_3 optimize the work parameters (operation amount, number of times to perform an operation, and the like) related to each operation involved in the maintenance work.

In addition, the stowable work robots 240_1 to 240_3 transmit performed work information regarding the work performed (the content of the operation of each work item) to the remote monitoring apparatus 210 after completion of the maintenance work. Furthermore, the work robot 220 updates work information upon receiving work information for update from the remote monitoring apparatus 210.

### <Work Items of Maintenance Work and State Measurement>

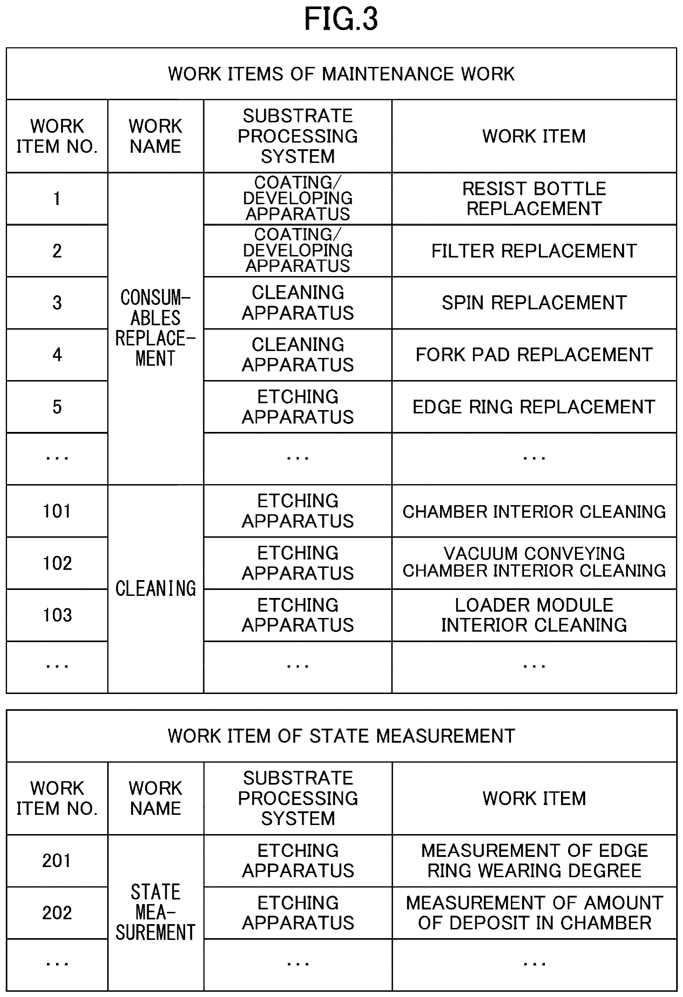

Next, the work items of the maintenance work performed by the work robot 220 and the stowable work robots 240_1 to 240_3 and the work items of the state measurement performed by the stowable work robots 240_1 to 240_3 will be described. FIG. 3 is a diagram showing an example of the work items of the maintenance work and the state measurement.

As shown in FIG. 3, the work names of the maintenance work for the substrate processing systems 121 to 123 can be roughly divided into "consumables replacement", and "cleaning".

Of these, "consumables replacement" refers to the maintenance work for replacing consumables inside the substrate processing systems 121 to 123.

As shown in FIG. 3, "consumables replacement" includes resist bottle replacement, filter replacement (work item numbers 1 and 2), and the like in the coating/developing apparatus. "Consumables replacement" also includes spin replacement, fork pad replacement (work item numbers 3 and 4), and the like in the cleaning apparatus. "Consumables replacement" also includes edge ring replacement (work item number 5) in the etching apparatus.

"Cleaning" refers to the maintenance work for cleaning the interiors (inner walls) of the substrate processing systems 121 to 123 (inner wall) and removing deposits.

As shown in FIG. 3, "cleaning" includes chamber interior cleaning, vacuum conveying chamber interior cleaning, loader module interior cleaning (work item numbers 101 to 103), and the like in the etching apparatus, and the like.

As shown in FIG. 3, the work name of the state measurement for the substrate processing systems 121 to 123 includes "state measurement". "State measurement" refers to the work for measuring the interiors of the substrate processing systems 121 to 123 in order to determine the necessity of maintenance work and determine the maintenance schedule.

As shown in FIG. 3, "state measurement" includes measurement of the edge ring wearing degree, measurement of the amount of deposit in the chamber (work item numbers 201 and 202), and the like in the etching apparatus.

Note that the work items of the maintenance work and the work items of the state measurement shown in FIG. 3 are only examples, and other work items may be included. Further, the respective work items of the maintenance work may be performed by either the work robot 220 or the stowable work robots 240_1 to 240_3. On the other hand, the respective work items of the state measurement are performed by the stowable work robots 240_1 to 240_3.

### <Specific Example of Target System>

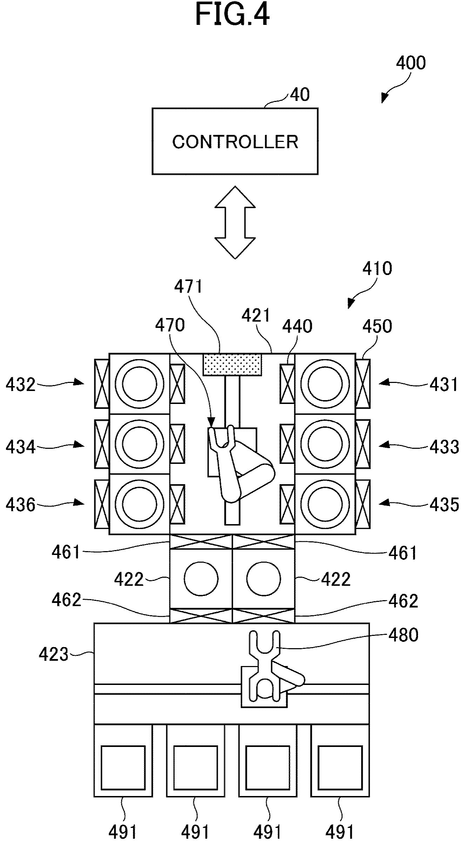

Next, a specific example of a substrate processing system that is a target system of the maintenance work by the maintenance work support system 110 according to the first embodiment will be described. A case where the substrate processing system 121 is an etching processing system 400 will be described. FIG. 4 is a view showing an example of the etching processing system that is a target system of the maintenance work.

As shown in FIG. 4, the etching processing system 400 includes a controller 40 and an etching apparatus 410.

The controller 40 communicates with the etching apparatus 410 and transmits information acquired from the etching apparatus 410 to the remote monitoring apparatus 210. The controller 40 also communicates with the remote monitoring apparatus 210, receives various instructions from the remote monitoring apparatus 210, and controls the etching apparatus 410.

The etching apparatus 410 includes a vacuum conveying chamber 421, a plurality of processing apparatuses 431 to 436, a plurality of load lock chambers 422, and an open-air conveying chamber 423.

The plurality of processing apparatuses 431 to 436 and the plurality of load lock chambers 422 are connected to the vacuum conveying chamber 421. In the example of FIG. 4, six processing apparatuses 431 to 436 are connected to the vacuum conveying chamber 421. However, five or less processing apparatuses or seven or more processing apparatuses may be connected to the vacuum conveying chamber 421. In the example of FIG. 4, two load lock chambers 422 are connected to the vacuum conveying chamber 421. However, one load lock chamber or three or more load lock chambers may be connected to the vacuum conveying chamber 421.

The vacuum conveying chamber 421 is provided with a stowing part 471. The stowable work robot 240_1 is stowed in the stowing part 471.

Each of the processing apparatuses 431 to 436 performs etching processing on a substrate in, for example, a low-pressure environment. Each of the processing apparatuses 431 to 436 is provided with consumables that are worn in response to processing on the substrate. Each of the processing apparatuses 431 to 436 and the vacuum conveying chamber 421 are separated from each other by a gate valve 440. Each of the processing apparatuses 431 to 436 is provided with a gate valve 450 for detaching and unloading consumables after use, attaching new consumables when the work robot 220 gains access to the etching apparatus 410 from outside.

Each load lock chamber 422 includes gate valves 461 and 462, to switch the internal pressure from a pressure of a predetermined vacuum degree to an open-air pressure or from the open-air pressure to a pressure of a predetermined vacuum degree. The load lock chambers 422 and the vacuum conveying chamber 421 are partitioned by the gate valves 461. The load lock chambers 422 and the open-air conveying chamber 423 are partitioned by the gate valves 462.

A robot arm 470 is provided in the vacuum conveying chamber 421. During the substrate processing period, the interior of the vacuum conveying chamber 421 is maintained at a predetermined vacuum degree. The robot arm 470 is a robot arm for conveying a substrate, and takes out a substrate before being processed from the interior of the load lock chamber 422 depressurized to a predetermined vacuum degree, and conveys it to one of the processing apparatuses 431 to 436. The robot arm 470 takes out a substrate after being processed from one of the processing apparatuses 431 to 436 and conveys it to another processing apparatus or the load lock chamber 422. Furthermore, the robot arm 470 is connected to the stowable work robot 240_1 stored in the stowing part 471 during the maintenance work or the state measurement, and performs the maintenance work or the state measurement of the interiors of the processing apparatuses 431 to 436 via, for example, the gate valves 440.

The open-air conveying chamber 423 is connected to the load lock chambers 422. A robot arm 480 is provided in the open-air conveying chamber 423. The open-air conveying chamber 423 is provided with a plurality of load ports 491 to which a container (for example, a Front Opening Unified Pod (FOUP)) capable of storing a plurality of substrates before or after being processed is connected. The robot arm 480 takes out a substrate before being processed from the container connected to the load port 491 and conveys it into the load lock chamber 422. The robot arm 480 takes out a substrate after being processed from the load lock chamber 422 and conveys it into the container connected to the load port 491. The open-air conveying chamber 423 may be provided with an alignment unit for adjusting the orientation of a substrate taken out from the container connected to the load port 491.

In this configuration, upon receiving a maintenance work instruction for the etching processing system 400 from the remote monitoring apparatus 210 after entry into the maintenance period, the work robot 220 moves to the position of the etching apparatus 410. Then, the work robot 220 performs maintenance work on the interiors of the processing apparatuses 431 to 436 via, for example, the gate valves 450.

### <Structure of Etching Apparatus>

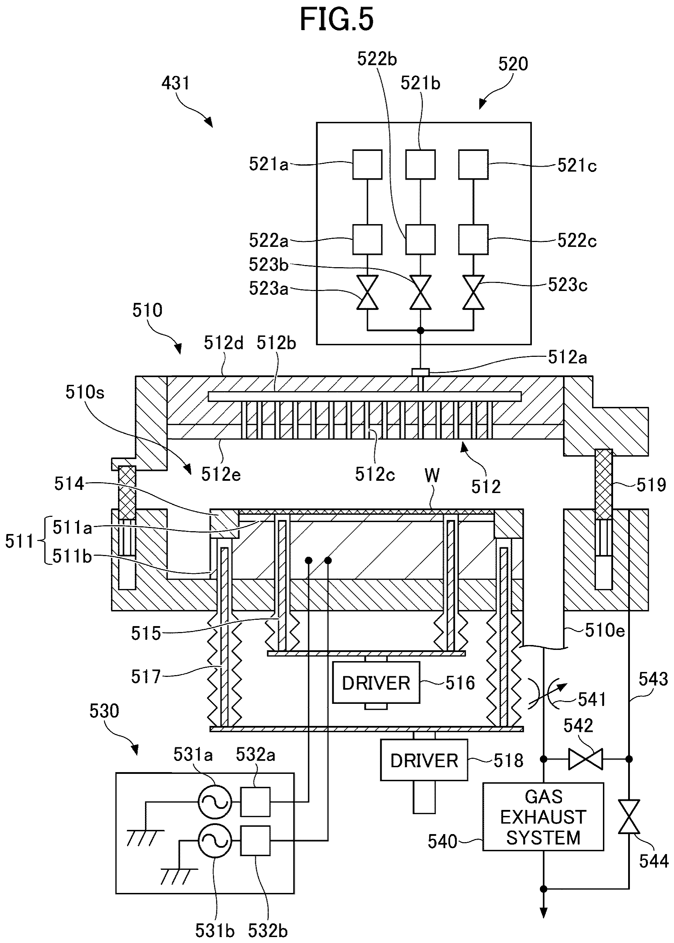

Next, the configuration of the etching apparatus 410 (here, the processing apparatus 431 thereof), which is a maintenance work target apparatus included in the etching processing system 400, will be described. FIG. 5 is a view showing an example of the etching apparatus that is a maintenance work target apparatus. As shown in FIG. 5, the processing apparatus 431 of the etching apparatus 410 includes a chamber 510, a gas supply 520, an Radio Frequency (RF) power supply 530, and a gas exhaust system 540.

The chamber 510 includes a support 511 and an upper electrode shower head assembly 512. The support 511 is located in a lower region of a processing space 510s in the chamber 510. The upper electrode shower head assembly 512 is located above the support 511 and functions as a part of a top plate of the chamber 510.

The support 511 is an example of a mounting table and is configured to support a substrate W in the processing space 510s. The support 511 includes a lower electrode 511b and an electrostatic chuck 511a. The electrostatic chuck 511a is disposed on the lower electrode 511b and is configured to support the substrate W on the upper surface of the electrostatic chuck 511a. An edge ring 514 is provided on the upper surface of the peripheral part of the lower electrode 511b. The edge ring 514 is disposed on the upper surface of the peripheral part of the lower electrode 511b so as to surround the electrostatic chuck 511a and the substrate W.

Through-holes for passing lift pins 515 are formed in the bottom of the chamber 510, the lower electrode 511b, and the electrostatic chuck 511a. The lift pins 515 are moved up and down by a driver 516 when loading or unloading the substrate W. Thus, the substrate W loaded into the chamber 510 can be received from the robot arm 470 and mounted on the electrostatic chuck 511a, and a substrate W after being processed can be passed to the robot arm 470 and unloaded from the chamber 510.

Through-holes for passing lift pins 517 are formed in the bottom of the chamber 510 and the lower electrode 511b. The lift pins 517 are moved up and down by a driver 518 when replacing the edge ring 514. Thus, a used edge ring 514 can be passed to the work robot 220 and unloaded from the chamber 510. Also, an edge ring (referred to as an edge ring 514') to be newly attached can be received from the work robot 220 and placed on the lower electrode 511b.

The upper electrode shower head assembly 512 is configured to supply one or more types of gases from the gas supply 520 into the processing space 510s. In the example of FIG. 5, the upper electrode shower head assembly 512 includes an electrode support 512d and an upper electrode 512e. The electrode support 512d includes a gas inlet 512a and a gas diffusion chamber 512b, and supports the upper electrode 512e on its lower surface. The gas supply 520 and the gas diffusion chamber 512b are in fluid communication via the gas inlet 512a. A plurality of gas outlets 512c are formed in the electrode support 512d and the upper electrode 512e, and the gas diffusion chamber 512b and the processing space 510s are in fluid communication via the plurality of gas outlets 512c. In the example of FIG. 5, the upper electrode shower head assembly 512 is configured to supply one or more types of gases from the gas inlet 512a to the processing space 510s via the gas diffusion chamber 512b and the plurality of gas outlets 512c.

The gas supply 520 includes a plurality of gas sources 521a to 521c, a plurality of flow rate controllers 522a to 522c, and a plurality of valves 523a to 523c. The gas source 521a is, for example, a supply source of a processing gas, the gas source 521b is, for example, a supply source of a cleaning gas, and the gas source 521c is, for example, a supply source of inert gas (for example, nitrogen gas).

The flow rate controllers 522a to 522c include, for example, a mass flow controller or a pressure-controlled flow rate controller. The gas supply 520 may also include one or more flow rate modulation devices that modulate or pulse the flow rate of one or more processing gases.

The RF power supply 530 is configured to supply RF power, for example, one or more RF powers, to one or more electrodes, such as the lower electrode 511b or the upper electrode shower head assembly 512, or both the lower electrode 511b and the upper electrode shower head assembly 512. In the example of FIG. 5, the RF power supply 530 includes two RF generators 531a and 531b, and two matching circuits 532a and 532b. In the example of FIG. 5, the RF power supply 530 is configured to supply a first RF power from the RF generator 531a to the lower electrode 511b via the matching circuit 532a. The RF spectrum includes a part of an electromagnetic spectrum from 3 [Hz] to 3,000 [GHz]. For an electronic material process such as a semiconductor process, the RF spectrum frequency used for plasma formation is preferably in the range of 100 [kHz] to 3 [GHz], more preferably in the range of 200 [kHz] to 150 [MHz]. For example, the frequency of the first RF power may be in the range of 27 [MHz] to 100 [MHz].

In the example of FIG. 5, the RF power supply 530 is configured to supply a second RF power from the RF generator 531b to the lower electrode 511b via the matching circuit 532b. For example, the frequency of the second RF power may be in the range of 400 [kHz] to 13.56 [MHz]. Alternatively, the RF power supply 530 may include a Direct Current (DC) pulse generator in place of the RF generator 531b.

The gas exhaust system 540 is connected via a pressure control valve 541 to a gas exhaust opening 510e provided at, for example, the bottom of the chamber 510. The gas exhaust system 540 may include a vacuum pump, such as a pressure valve, a turbomolecular pump, a roughing pump, or a combination thereof. A pipe 543 is connected between the pressure control valve 541 and the gas exhaust system 540 via a valve 542. The pipe 543 is connected to a space outside a gate valve 519. Gas exhausted by the gas exhaust system 540 is exhausted from a gas exhaust port of the gas exhaust system 540 to an exhaust gas treatment system for treating exhaust gas. The pipe 543 is connected to the gas exhaust port of the gas exhaust system 540 via a valve 544.

### <Work Quality Measurement Items>

Next, work quality measurement items in a case where the substrate processing system 121, which is the target system, is the etching processing system 400, and maintenance work is performed on the processing apparatus 431 of the etching apparatus 410 will be described. As described above, the work robot 220 and the stowable work robot 240_1 check measurement results of measurement items falling within work qualities (i.e., results obtained by measuring work quality measurement items) during maintenance work, and continue to operate until a predetermined criterion is satisfied.

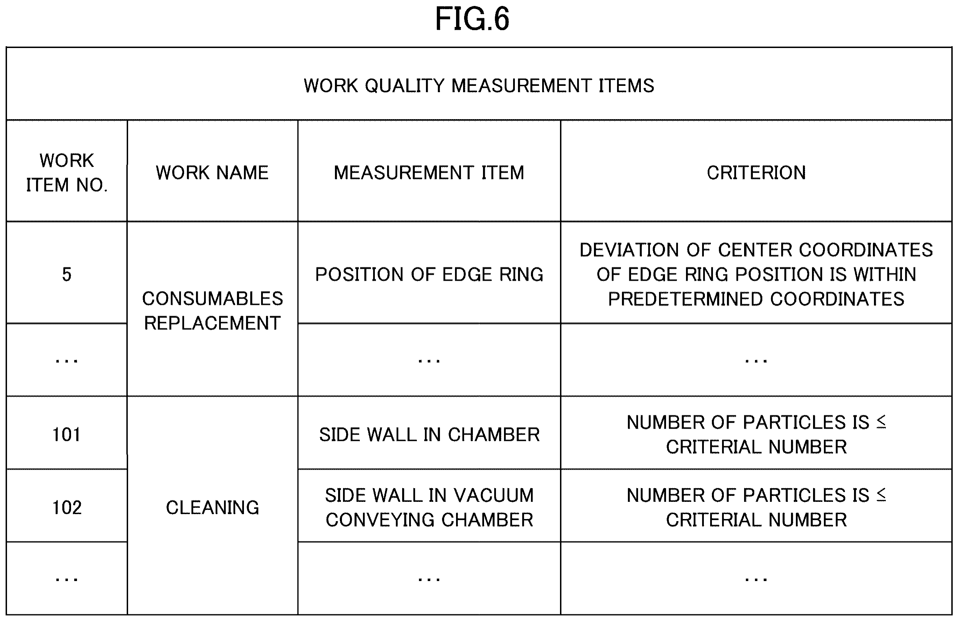

FIG. 6 is a diagram showing an example of the work quality measurement items during maintenance work for the etching apparatus.

As shown in FIG. 6, for example, it is assumed that regarding the processing apparatus 431 of the etching apparatus 410, the work robot 220 has replaced edge rings, which are consumable articles. In this case, the work robot 220 measures the position of the edge ring 514', which is a consumable article newly installed. In addition, the work robot 220 adjusts the position of the edge ring 514' as an additional operation such that the amount of deviation of the coordinates indicating the position of the edge ring 514' from the target coordinate becomes equal to or less than a predetermined threshold.

In addition, as shown in FIG. 6, for example, it is assumed that regarding the processing apparatus 431 of the etching apparatus 410 and the vacuum conveying chamber 421, the stowable work robot 240_1 has cleaned the interior of the chamber 510 and the interior of the vacuum conveying chamber 421. In this case, the stowable work robot 240_1 measures the number of particles on the side wall. In addition, the stowable work robot 240_1 additionally cleans the interior of the chamber 510 and the interior of the vacuum conveying chamber 421 until the number of particles on the side wall becomes equal to or less than a criterial number.

In this way, the work robot 220 and the stowable work robot 240_1 measure the work qualities regarding measurement items specified for the respective work items, and perform the maintenance work until the predetermined criterion is satisfied. Thus, the maintenance work support system 110 according to the first embodiment can ensure maintenance work quality consistency at or greater than the criterion value. The criterion here may be set as a fixed value, or may be changed as appropriate by the worker, the remote monitoring person 250, or the like.

### <Details of Work Robot and Stowable Work Robots>

Next, details of the work robot 220 and the stowable work robots 240_1 to 240_3 will be described.

### (1) Configuration of Work Robot 220

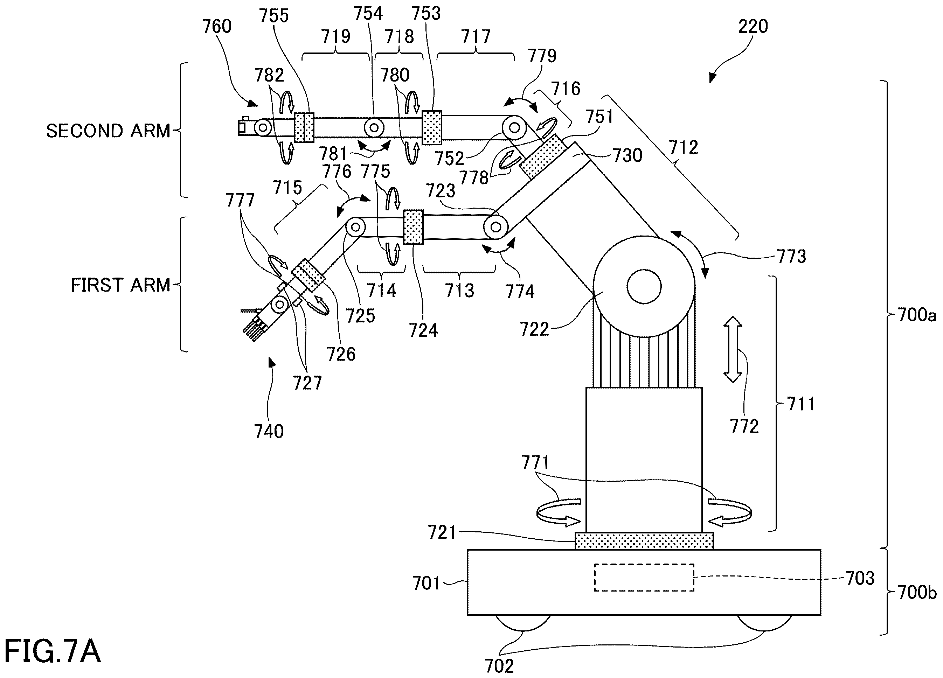

First, the detailed configuration of the work robot 220 will be described. FIG. 7A is a view showing an example of the work robot. As shown in FIG. 7A, the work robot 220 includes a manipulator 700a and a travelling body 700b.

The travelling body 700b moves the work robot 220 and controls the position and posture of the entire work robot 220. The travelling body 700b includes a support base 701, a travelling part 702, and a controller 703.

The support base 701 is a base for supporting the manipulator 700a. The travelling part 702 is controlled based on image data and distance data from an imaging device and a laser device (not shown) attached to the support base 701. Thus, the travelling part 702 can move the work robot 220 to a desirable position (for example, the position of the target system). The controller 703 controls the operation of the manipulator 700a and the operation of the travelling part 702.

The manipulator 700a mainly performs consumables replacement and cleaning among the maintenance work for the substrate processing systems 121 to 123. The manipulator 700a measures work qualities after consumables replacement and cleaning.

As shown in FIG. 7A, the manipulator 700a includes a plurality of link parts (link parts 711 to 719).

One end of the link part 711 is attached to the travelling body 700b via a rotating part 721 rotating in the direction of an arrow 771. The link part 711 has an elevating mechanism that moves up and down in the direction of an arrow 772, and one end of the link part 712 is attached to the other end of the link part 711 via a rotating part 722 rotating in the direction of an arrow 773.

A branch part 730 is formed at the other end of the link part 712, and a first arm that mainly performs consumables replacement and cleaning, and a second arm that measures the work qualities after consumables replacement and cleaning are attached to the branch part 730.

In the first arm, one end of the link part 713 is attached to the branch part 730 via a rotating part 723 rotating in the direction of an arrow 774, and the other end thereof is attached to the link part 714 via a rotating part 724 rotating in the direction of an arrow 775. One end of the link part 715 is attached to the other end of the link part 714 via a rotating part 725 rotating in the direction of an arrow 776. Further, an end effector 740 is attached to the other end of the link part 715 via a rotating part 726 rotating in the direction of an arrow 777.

The end effector 740 includes a sensor (for example, an imaging device 727) and measures the direction of the tip of the end effector 740. As a result, the posture of the first arm is controlled, and the operation of the end effector 740 is controlled, to perform consumables replacement and cleaning.

Although the example of FIG. 7A shows an example in which a five finger-type end effector is attached as the end effector 740, the type of the end effector 740 is not limited to this, and an appropriate type of an end effector is substituted in accordance with the work item. Specifically, a plurality of types of end effectors are conveyed to the vicinity of the work robot 220 by the conveying robot 230, and the work robot 220 replaces the end effector with another one that is suited to the work item. Alternatively, the work robot 220 may replace the end effector with another one that is suited to the work item from among a plurality of types of end effectors stocked therein. The end effector 740 is detachably attached at the position of the rotating part 726.

In the second arm, one end of the link part 716 is attached to a branch part 730 via a rotating part 751 rotating in the direction of an arrow 778, and the other end thereof is attached to the link part 717 via a rotating part 752 rotating in the direction of an arrow 779. One end of the link part 718 is attached to the other end of the link part 717 via a rotating part 753 rotating in the direction of an arrow 780. One end of the link part 719 is attached to the other end of the link part 718 via a rotating part 754 rotating in the direction of an arrow 781. Furthermore, a multi-sensor unit 760 is attached to the other end of the link part 719 via a rotating part 755 rotating in the direction of an arrow 782.

The multi-sensor unit 760 is an example of a measurement unit and includes various sensors (for example, an imaging device, and a laser range finder). Thus, the posture of the second arm is controlled, to measure the work qualities of the consumables replacement and cleaning performed by the end effector 740.

### (2) Configuration of Stowable Work Robots 240_1 to 240_3

Next, the detailed configuration of the stowable work robots 240_1 to 240_3 will be described. Since the stowable work robots 240_1 to 240_3 have the same configuration, the detailed configuration of the stowable work robot 240_1 will be described here.

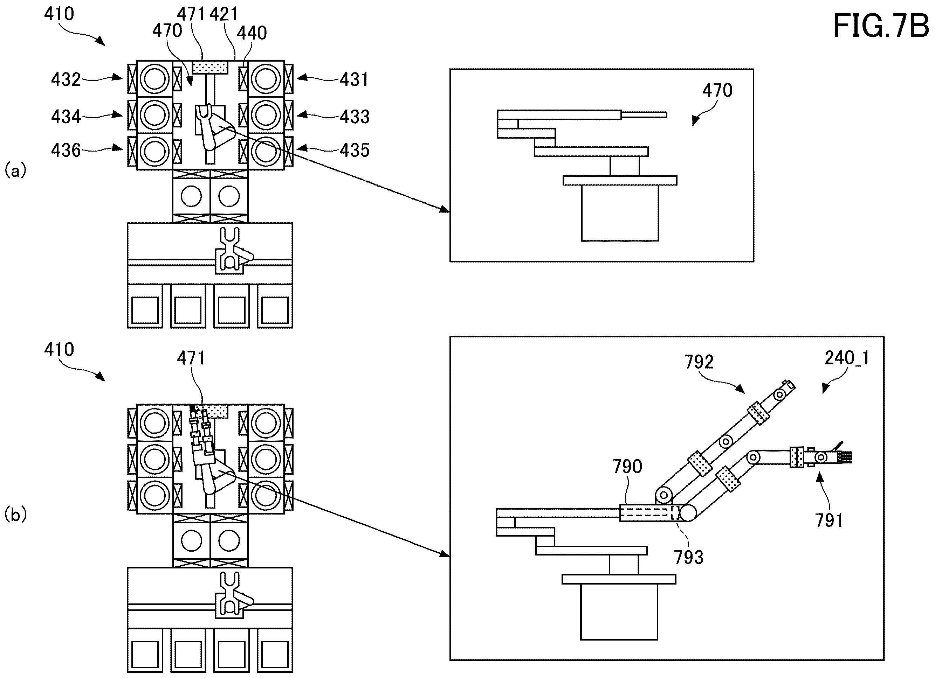

The stowable work robot 240_1 is stowed in the vacuum conveying chamber 421 when the substrate processing system 121, which is a target system, is the etching processing system 400. The stowable work robot 240_1 is connected to the robot arm 470 when there is a state measurement instruction or maintenance work instruction from the remote monitoring apparatus 210. FIG. 7B is a view showing an example of the stowable work robot, wherein (a) shows a state before the stowable work robot 240_1 is connected to the robot arm 470, and (b) shows a state after the stowable work robot 240_1 is connected to the robot arm 470.

The left side of the drawing sheet of FIG. 7B (a) shows a state of the etching apparatus 410 described with reference to FIG. 4, viewed from above. The right side of the drawing sheet shows a state of the robot arm 470 viewed from a side. As described above, the robot arm 470 conveys a substrate before being processed to one of the processing apparatuses 431 to 436, and takes out the substrate after being processed from one of the processing apparatuses 431 to 436. For this reason, as shown on the right side of the drawing sheet, the height position of the tip of the robot arm 470 is, for example, at the height of the gate valve 440, and has a link mechanism in which a plurality of links are connected via a plurality of rotating parts.

The left side of the drawing sheet in FIG. 7B (b) shows a state in which the stowable work robot 240_1 is connected to the robot arm 470 in the etching apparatus 410 viewed from above. The right side of the drawing sheet shows a state in which the robot arm 470 to which the stowable work robot 240_1 is connected is viewed from a side.

As shown on the right side of the drawing sheet in FIG. 7B (b), the stowable work robot 240_1 has a connection part 790 and is connected to the tip of the robot arm 470. A controller 793 is provided in the connection part 790 and controls the operation of the stowable work robot 240_1.

Specifically, two arms are attached to the connection part 790 and perform maintenance work (consumables replacement and cleaning) and state measurement for the etching processing system 400. One of the two arms measures the work quality during maintenance work (after consumables replacement or after cleaning).

Since the two arms attached to the connection part 790 have the same configuration as that of the first arm and the second arm of the work robot 220 described with reference to FIG. 7A, the description here will focus on the differences from the first arm and the second arm of the work robot 220.

An end effector 791 is an end effector having a finger mechanism including a plurality of fingers (for example, a five-fingered type), and deforms into a shape suitable for a work item by the fingers closely contacting or separating from each other (in other words, by changing the finger spacing). For example, when gripping a heavy object, the fingers combine with each other to form two wide fingers. When gripping a small object, the fingers separate from each other to form five thin fingers. Furthermore, when cleaning the inner wall of a chamber with cloth, the fingers combine with each other and form a flat surface, to increase the contact area between the inner wall of the chamber and the cloth.

A multi-sensor unit 792 includes a UV light in addition to various sensors (for example, an imaging device and a laser range finder). Thus, in the work quality measurement accompanying cleaning performed by the end effector 791, it is possible to detect the number of particles in the chamber by UV light irradiation.

### <Example of Operation of Work Robot and Stowable Work Robot>

Next, examples of operations of the work robot 220 and the stowable work robot 240_1 will be described.

### (1) Example of Operation of Work Robot 220 (Consumables Replacement)

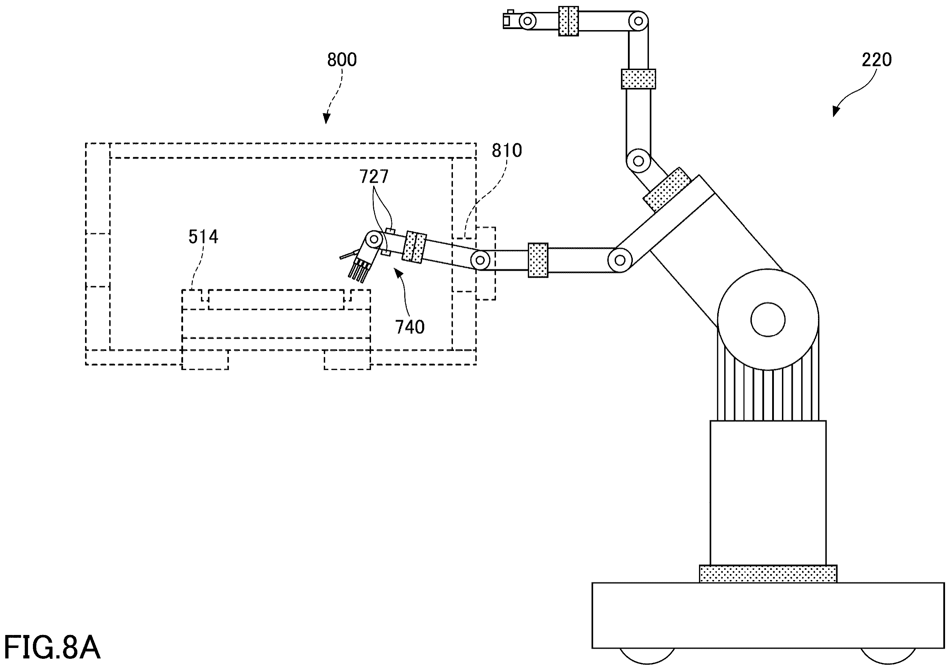

First, an example of the operation of the work robot 220 when replacing consumables (here, the edge ring 514 in the processing apparatus 431 of the etching apparatus 410) will be described. FIG. 8A is a first view showing an example of the operation of the work robot. As shown in FIG. 8A, the work robot 220 accesses a processing apparatus (here, the processing apparatus 431) of which the edge ring is to be replaced among the plurality of processing apparatuses of the etching apparatus 410. In FIG. 8A, a chamber 800 schematically represents the chamber 510 of the processing apparatus 431.

As shown in FIG. 8A, the work robot 220 accessing the processing apparatus 431 controls the first arm to be inserted into the chamber 800 via a gate 810 of the chamber 800. Specifically, the work robot 220 inserts the first arm into the chamber 800 while controlling the posture of the first arm based on image data captured by the sensor (for example, the imaging device 727).

Furthermore, the work robot 220 detaches the used edge ring 514 by using the first arm, unloads the detached edge ring 514 to outside the chamber 800, and passes it to the conveying robot 230 (not shown in FIG. 8A). Specifically, the work robot 220 detaches the edge ring 514 while controlling the operation of the end effector 740 based on image data captured by the sensor (for example, the imaging device 727). Furthermore, the work robot 220 unloads and passes down the detached edge ring 514 while controlling the posture of the first arm based on image data captured by the sensor (for example, the imaging device 727).

Furthermore, the work robot 220 grips the edge ring 514' to be newly installed, which has been previously delivered by the conveying robot 230, and loads it into the chamber 800 via the gate 810. Furthermore, the work robot 220 attaches the new edge ring 514' to a predetermined position, and when completing the attachment, pulls out the first arm to outside the chamber 800.

### (2) Example of Operation of Work Robot 220 (Measurement of Work Quality)

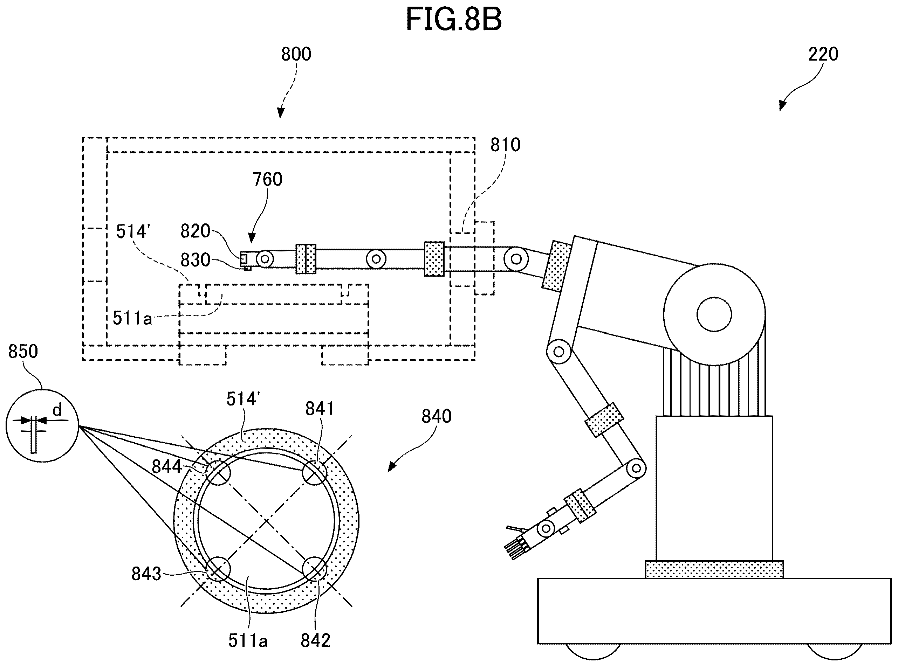

Next, an example of the operation of the work robot 220 when measuring the work quality after attaching a new edge ring 514' will be described. FIG. 8B is a second view showing an example of the operation of the work robot. As shown in FIG. 8B, the work robot 220 controls the second arm to be inserted into the chamber 800 via the gate 810 of the chamber 800. Specifically, the work robot 220 inserts the second arm into the chamber 800 while controlling the posture of the second arm based on image data captured by the sensor (for example, an imaging device 820) of the multi-sensor unit 760.

The work robot 220 measures the attachment position of the newly attached edge ring 514' by the sensor (for example, a laser range finder 830) of the multi-sensor unit 760. In FIG. 8B, the reference numeral 840 shows a state of the newly attached edge ring 514' and the electrostatic chuck 511a when viewed from above.

The work robot 220 measures the distance while moving the sensor (for example, the laser range finder 830) of the multi-sensor unit 760 in parallel with the upper surface of the edge ring 514' and the upper surface of the electrostatic chuck 511a along, for example, the dashed lines at the reference numeral 840. Thus, for example, the work robot 220 acquires a measurement result indicated by the reference numeral 850 at each of the positions indicated by the reference numerals 841 to 844.

In other words, the work robot 220 can calculate the distance d between the inner end of the edge ring 514' and the outer end of the electrostatic chuck 511a at each of the positions indicated by the reference numerals 841 to 844. As a result, the work robot 220 can calculate the amount of deviation of the center position (target coordinates) of the edge ring 514' from the center position (coordinates) of the electrostatic chuck 511a.

The work robot 220 determines whether or not the calculated amount of deviation is equal to or less than a predetermined threshold. When determining that the amount of deviation is not equal to or less than the predetermined threshold, the work robot 220 again inserts the first arm into the chamber 800 as shown in FIG. 8A, and performs an additional operation to perform position adjustment of the attachment position of the newly attached edge ring 514'. The work robot 220 continues these operations until it determines that the calculated amount of deviation is equal to or less than the predetermined threshold.

### (3) Example of Operation of Stowable Work Robot 240_1 (State Measurement)

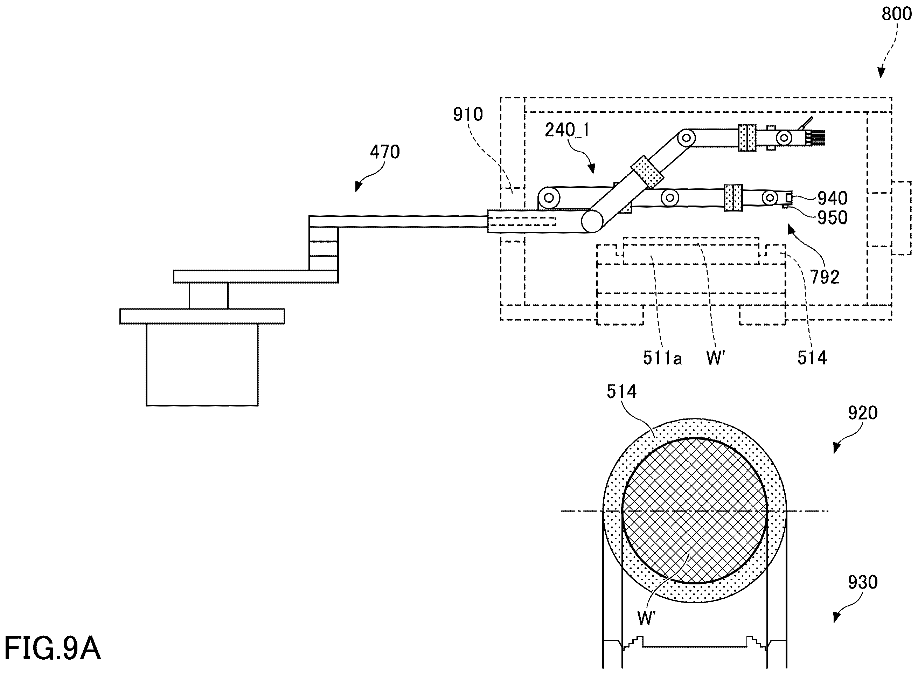

Next, an example of the operation of the stowable work robot 240_1 when performing the state measurement (here, measurement of the wearing degree of the edge ring 514 in the processing apparatus 431 of the etching apparatus 410) will be described. FIG. 9A is a first view showing an example of the operation of the stowable work robot.

As shown in FIG. 9A, when the stowable work robot 240_1 performs the state measurement, first, the robot arm 470 connects the stowable work robot 240_1 to the tip thereof. Subsequently, the robot arm 470 accesses the processing apparatus (here, the processing apparatus 431) to which the edge ring 514, of which the wearing degree is to be measured, is attached, among the plurality of processing apparatuses included in the etching apparatus 410. Similarly to FIG. 8A, in FIG. 9A, the chamber 800 schematically represents the chamber 510 of the processing apparatus 431.

The robot arm 470 accessing the processing apparatus 431 controls the stowable work robot 240_1 to be inserted into the chamber 800 via a gate 910 of the chamber 800. Specifically, the robot arm 470 inserts the stowable work robot 240_1 into the chamber 800 based on image data captured by the sensor (for example, an imaging device 940) of the multi-sensor unit 792 of the stowable work robot 240_1. It is assumed that when inserting the stowable work robot 240_1 into the chamber 800, a jig substrate W' has been mounted on the electrostatic chuck 511a beforehand.

When the stowable work robot 240_1 is inserted into the chamber 800, the stowable work robot 240_1 measures the wearing degree of the edge ring 514 by, for example, a sensor (for example, a laser range finder 950) of the multi-sensor unit 792. In FIG. 9A, a state of the edge ring 514 and the jig substrate W' viewed from above is shown at the reference numeral 920.

The stowable work robot 240_1 measures the distance while moving the sensor (for example, the laser range finder 950) of the multi-sensor unit 792 in parallel with the upper surface of the edge ring 514 and the upper surface of the jig substrate W' along, for example, the dashed line at the reference numeral 920. Thus, the stowable work robot 240_1 acquires, for example, a measurement result indicated by the reference numeral 930. As a result, the stowable work robot 240_1 can calculate the wearing degree of the edge ring 514.

The stowable work robot 240_1 transmits the calculated wearing degree to the remote monitoring apparatus 210 as a state measurement result. Thus, the remote monitoring apparatus 210 can determine whether or not the edge ring 514 needs to be replaced, or determine the maintenance timing and the maintenance schedule.

### (4) Example of Operation of Stowable Work Robot 240_1 (Cleaning)

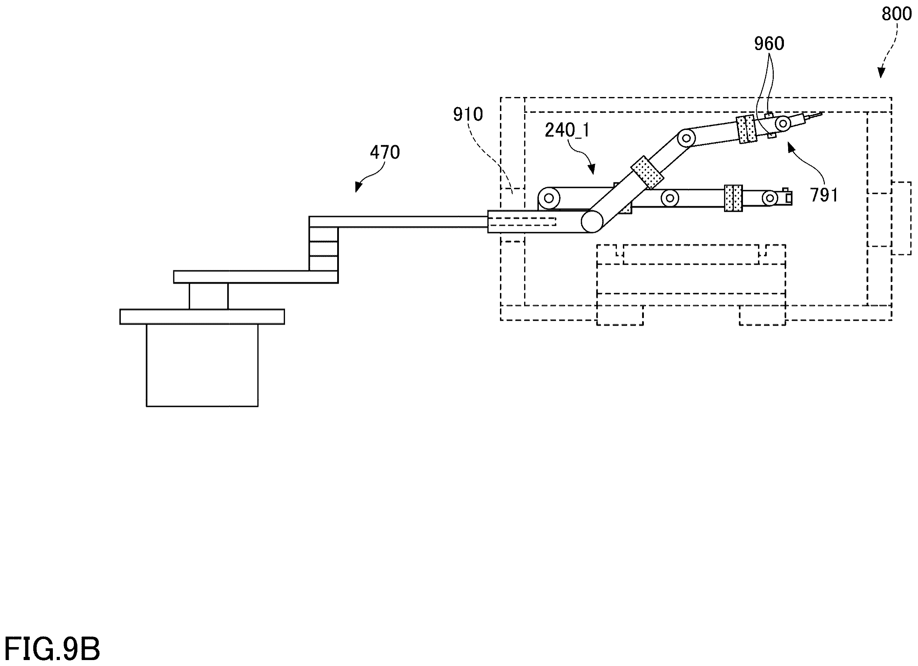

Next, an example of the operation of the stowable work robot 240_1 when performing cleaning (here, cleaning of the interior of the chamber 510 in the processing apparatus 431 of the etching apparatus 410) will be described. FIG. 9B is a second view showing an example of the operation of the stowable work robot.

As shown in FIG. 9B, when the stowable work robot 240_1 performs cleaning, first, the robot arm 470 connects the stowable work robot 240_1 to the tip thereof. Subsequently, the robot arm 470 accesses a processing apparatus (here, the processing apparatus 431) of which the chamber is to be cleaned among the plurality of processing apparatuses of the etching apparatus 410. Similarly to FIG. 9A, in FIG. 9B, the chamber 800 schematically represents the chamber 510 of the processing apparatus 431.

The robot arm 470 accessing the processing apparatus 431 controls the stowable work robot 240_1 to be inserted into the chamber 800 via the gate 910 of the chamber 800. Specifically, the robot arm 470 inserts the stowable work robot 240_1 into the chamber 800 based on image data captured by a sensor (for example, an imaging device 960) of the end effector 791 of the stowable work robot 240_1. It is assumed that when inserting the stowable work robot 240_1 into the chamber 800, the end effector 791 holds a cloth for cleaning the inner wall of the chamber 800.

When the stowable work robot 240_1 is inserted into the chamber 800, the stowable work robot 240_1 cleans the inner wall of the chamber 800 using the cloth held by the end effector 791. Specifically, the stowable work robot 240_1 performs cleaning by controlling the operation of the end effector 791 while controlling the posture of the first arm based on image data captured by the sensor (for example, the imaging device 960). The stowable work robot 240_1 may perform a predetermined operation as the cleaning work or may perform an operation suited to the state of contamination (the type of contamination, the area of contamination, and the like). The stowable work robot 240_1 gains knowledge of the state of contamination via, for example, the multi-sensor unit 792.

### (5) Example of Operation of Stowable Work Robot 240_1 (Measurement of Work Quality)

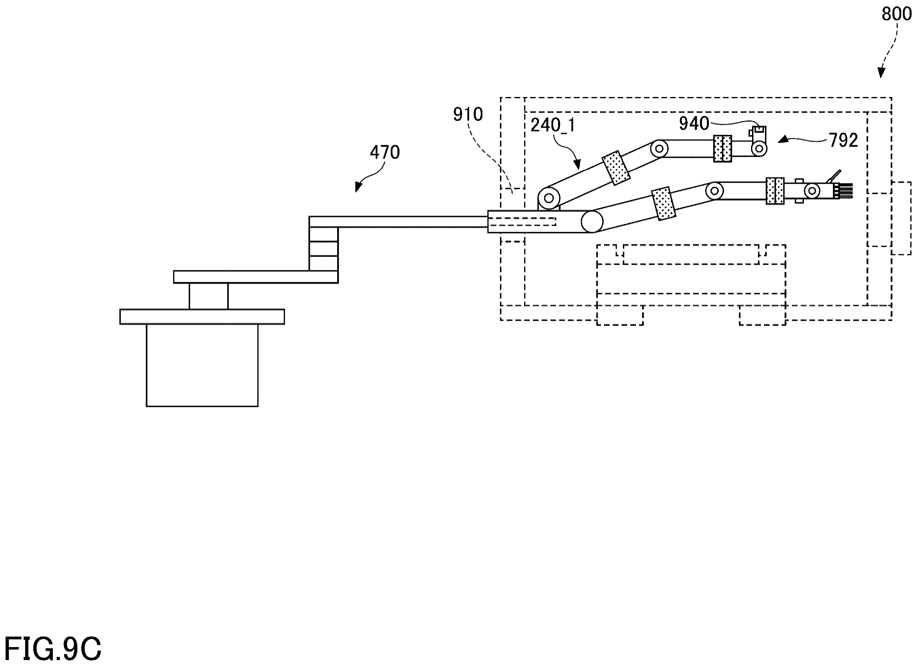

Next, an example of the operation of the stowable work robot 240_1 when measuring the work quality after cleaning will be described. FIG. 9C is a third view showing an example of the operation of the stowable work robot. As shown in FIG. 9C, when cleaning of the inner wall of the chamber 800 is completed, the stowable work robot 240_1 is in the state of being inserted in the chamber 800.

Therefore, the stowable work robot 240_1 measures the number of particles in the chamber 800 using the second arm. Specifically, the UV light of the multi-sensor unit 792 of the second arm irradiates the inner wall of the chamber 800, and a sensor (for example, the imaging device 940) of the multi-sensor unit 792 of the second arm captures an image of the position irradiated by the UV light.

Thus, the stowable work robot 240_1 can measure the number of particles in the chamber 800 as a work quality of the cleaning performed by the end effector 791.

The stowable work robot 240_1 determines whether or not the measured number of particles is equal to or less than a predetermined threshold, and when determining that the number of particles is not equal to or less than the predetermined threshold, performs cleaning by the end effector 791 again as shown in FIG. 9B. The stowable work robot 240_1 continues these operations until it determines that the measured number of particles is equal to or less than the predetermined threshold.

### <Hardware Configuration of Controllers of Work Robot and Stowable work robot>

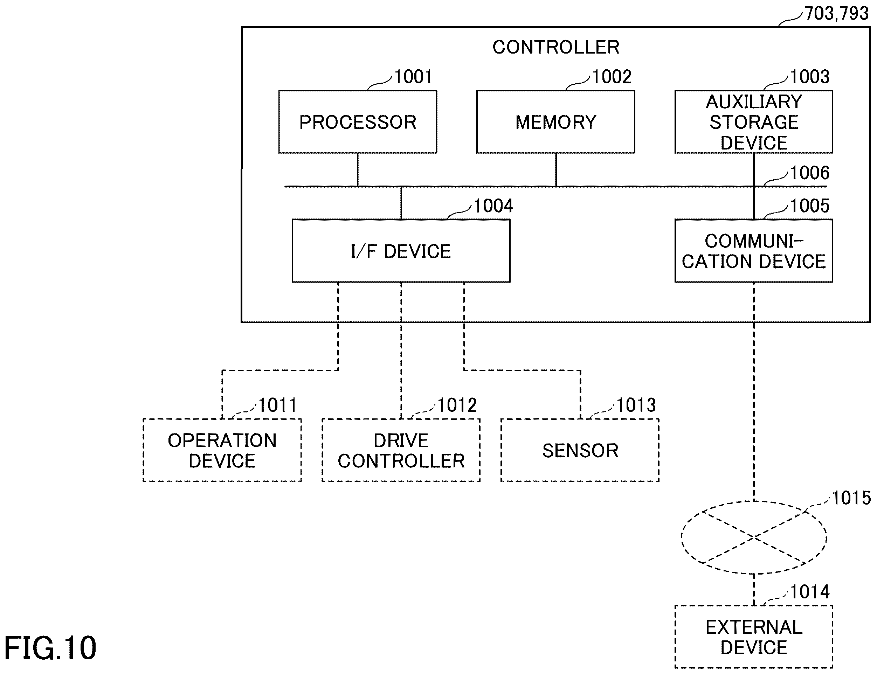

Next, the hardware configuration of the controllers (for example, controllers 703 and 793) of the work robot (for example, the work robot 220) and the stowable work robot (for example, the stowable work robot 240_1) will be described. FIG. 10 is a diagram showing an example of the hardware configuration of the controllers of the work robot and the stowable work robot.

As shown in FIG. 10, the controllers 703 and 793 include a processor 1001, a memory 1002, an auxiliary storage device 1003, an interface (I/F) device 1004, and a communication device 1005. Each hardware component included in the controllers 703 and 793 are connected to each other via a bus 1006.

The processor 1001 includes various computing devices, such as a Central Processing Unit (CPU), a Graphics Processing Unit (GPU), and the like. The processor 1001 reads out various programs (for example, a control program) into the memory 1002 and executes the programs.

The memory 1002 includes main storage devices, such as a Read Only Memory (ROM), a Random Access Memory (RAM), and the like. The processor 1001 and the memory 1002 form what is generally referred to as a computer, and the computer realizes various functions by the processor 1001 executing various programs read out into the memory 1002.

The auxiliary storage device 1003 stores various programs and various information used when the various programs are executed by the processor 1001.

The I/F device 1004 is a connection device for connecting to external devices (an operation device 1011, a drive controller 1012, a sensor 1013, and the like). The I/F device 1004 receives a worker's operation on the work robot 220 or the stowable work robot 240_1 via the operation device 1011. The operation device 1011 here includes an operation switch for turning ON/OFF the power sources of the work robot 220 and the stowable work robot 240_1, an operation switch for emergency stop, and the like.

The I/F device 1004 outputs control instructions from the controllers 703 and 793 to the drive controller 1012. The drive controller 1012 includes a device that outputs operation signals for controlling travelling of the work robot 220 and the operations of the first and second arms, or the operations of the first and second arms of the stowable work robot 240_1.

Furthermore, the I/F device 1004 receives sensor data from the sensor 1013. The sensor 1013 here includes various sensors included in the work robot 220, such as the sensor of the multi-sensor unit 760, the sensor of the end effector 740, the sensors of the manipulator 700a, and the sensor of the travelling body 700b.

Alternatively, the sensor 1013 here includes various sensors included in the stowable work robot 240_1, such as the sensor of the multi-sensor unit 792, the sensor of the end effector 791, and the like.

The communication device 1005 is a communication device for communicating with an external device 1014 (for example, other robots, devices, and the like in the maintenance work support system 110) via a network 1015.

Various programs to be installed in the auxiliary storage device 1003 are installed by, for example, being downloaded from the network 1015 via the communication device 1005.

### <Functional Configuration of Controllers of Work Robot and Stowable Work Robot>

Next, the functional configuration of the controller 703 of the work robot 220 and the controller 793 of the stowable work robot 240_1 will be described. The functional configuration will be described dividedly for each of the following:
- a "first travelling phase" in which the work robot 220 receives a maintenance work instruction and travels to the position of the target system (etching processing system 400);
- a "second travelling phase" in which the stowable work robot 240_1 receives a state measurement instruction or a maintenance work instruction and the robot arm 470 inserts the stowable work robot 240_1 into the chamber 510 of the processing apparatus 431 of the target apparatus (etching apparatus 410); and
- a "work phase" in which the work robot 220 or the stowable work robot 240_1 performs the maintenance work, the state measurement, or the work quality measurement.

### (1) Functional Configuration in First Travelling Phase

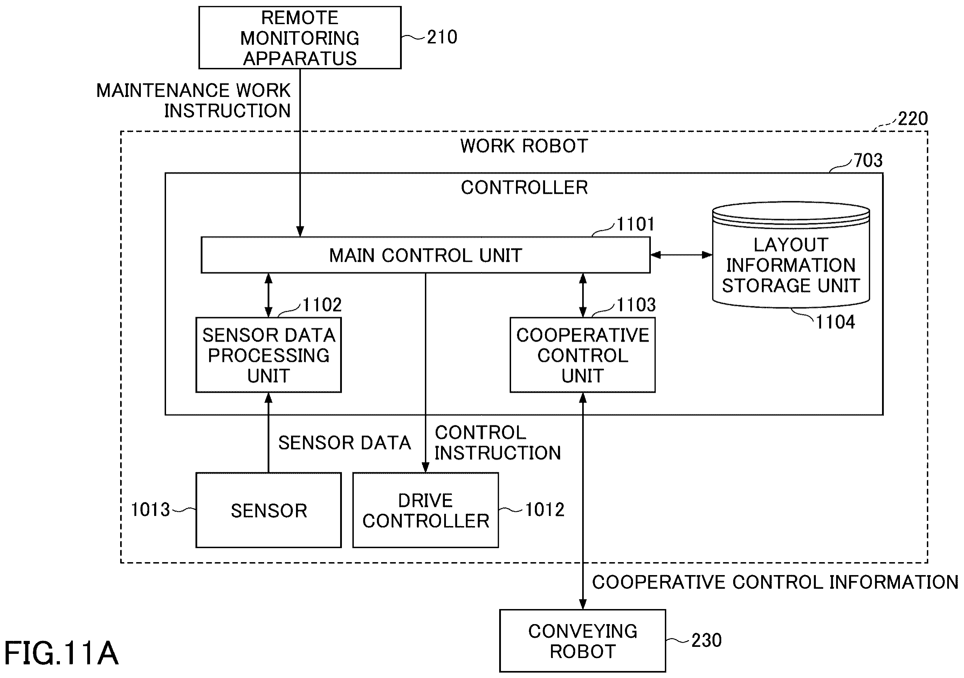

First, the functional configuration of the controller 703 of the work robot 220 in the first travelling phase will be described. FIG. 11A is a diagram showing an example of the functional configuration of the controller of the work robot in the first travelling phase. A control program is installed in the controller 703 of the work robot 220. When the control program is executed in the first travelling phase, the controller 703 functions as a main control unit 1101, a sensor data processing unit 1102, and a cooperative control unit 1103.

Upon receiving a maintenance work instruction from the remote monitoring apparatus 210, the main control unit 1101 identifies the target system of the maintenance work and acquires the current position/posture information of the work robot 220 from the sensor data processing unit 1102. The main control unit 1101 reads the layout information indicating the layout in the substrate manufacturing factory 120 stored in a layout information storage unit 1104, and derives the travelling path to the identified target system based on the current position/posture information. Furthermore, the main control unit 1101 outputs a control instruction to the drive controller 1012 based on the current position/posture information indicating the current position and posture during the travelling, such that travelling is performed according to the derived travelling path.

When obstacle information is acquired from the sensor data processing unit 1102 during travelling along the travelling path, the main control unit 1101 adjusts the control instruction to be output to the drive controller 1012 based on the acquired obstacle information.

The main control unit 1101 exchanges cooperative control information with the conveying robot 230 via the cooperative control unit 1103. The cooperative control information is instruction information for efficiently performing maintenance work, and includes both instructions from the conveying robot 230 to the work robot 220 and instructions from the work robot 220 to the conveying robot 230.

The cooperative control unit 1103 transmits the cooperative control information output from the main control unit 1101 to the conveying robot 230, and provides the cooperative control information transmitted from the conveying robot 230 to the main control unit 1101 as a notification.

### (2) Functional Configuration in Second Travelling Phase

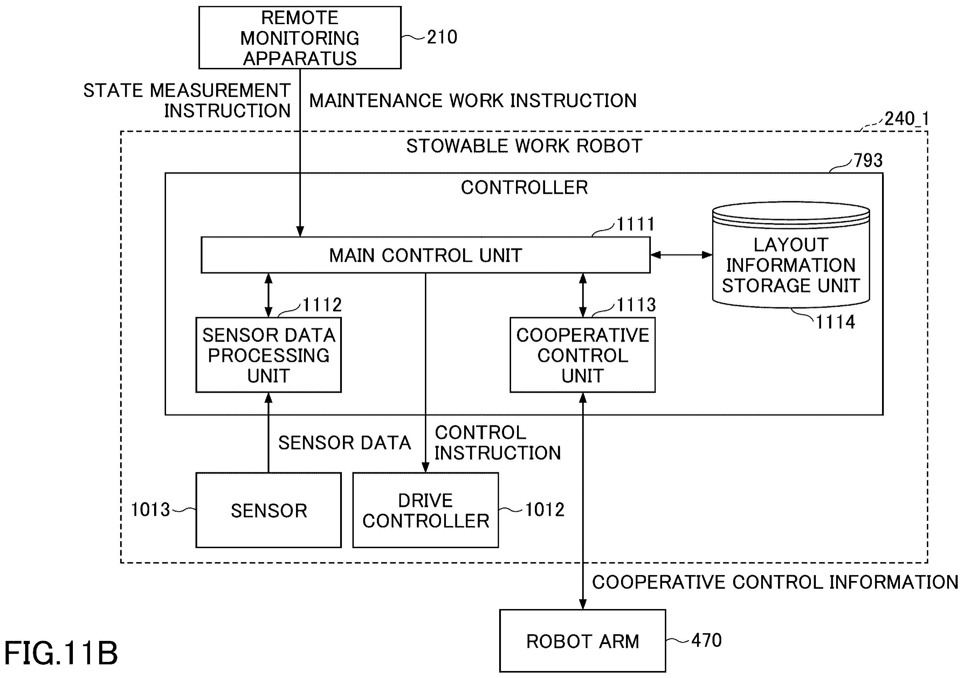

Next, the functional configuration of the controller 793 of the stowable work robot 240_1 in the second travelling phase will be described. FIG. 11B shows an example of the functional configuration of the controller of the stowable work robot in the second travelling phase. A control program is installed in the controller 793 of the stowable work robot 240_1. The controller 793 of the stowable work robot 240_1 functions as a main control unit 1111, a sensor data processing unit 1112, and a cooperative control unit 1113 by executing the control program in the second travelling phase.

Upon receiving a state measurement instruction from the remote monitoring apparatus 210, the main control unit 1111 identifies a processing apparatus in which the state measurement is to be performed. Upon receiving a maintenance work instruction from the remote monitoring apparatus 210, the main control unit 1111 identifies a processing apparatus in which the maintenance work is to be performed.

Upon detecting that the robot arm 470 is connected to the stowable work robot 240_1, the main control unit 1111 performs cooperative control with the robot arm 470 via the cooperative control unit 1113 to control the position and posture of the stowable work robot 240_1.

Specifically, the main control unit 1111 acquires the current position/posture information from the sensor data processing unit 1112. The main control unit 1111 reads out layout information indicating the layout of the processing apparatuses 431 to 436 in the substrate processing system 121, stored in a layout information storage unit 1114. In addition, in order for the stowable work robot 240_1 to be inserted into the chamber of the identified processing apparatus, the main control unit 1111
- controls the position and posture of the stowable work robot 240_1 by outputting a control instruction to the drive controller 1012, and
- controls the position and posture of the robot arm 470 by outputting cooperative control information to the robot arm 470 via the cooperative control unit 1113,
based on the acquired current position/posture information.

### (3) Functional Configuration in Work Phase

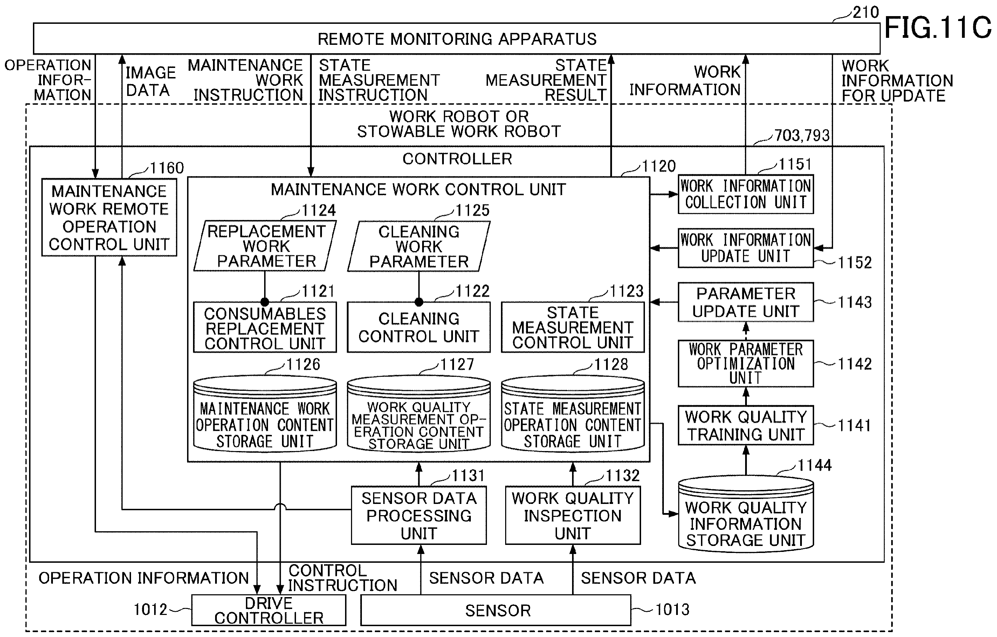

Next, the functional configuration of the controller 703 of the work robot 220 and the controller 793 of the stowable work robot 240_1 in the work phase will be described. Since the functional configuration of the controller 703 of the work robot 220 in the work phase and the functional configuration of the controller 793 of the stowable work robot 240_1 in the work phase are the same or similar, the functional configuration in the work phase will be described collectively using FIG. 11C.

FIG. 11C shows an example of the functional configuration of the controllers of the work robot and the stowable work robot in the work phase. As described above, a control program is installed in the controller 703 of the work robot 220 and the controller 793 of the stowable work robot 240_1. Then, when the control program is executed in the work phase, the controller 703 or the controller 793 functions as
- a maintenance work control unit 1120;
- a sensor data processing unit 1131 and a work quality inspection unit 1132;
- a work quality training unit 1141, a work parameter optimization unit 1142, and a parameter update unit 1143;
- a work information collection unit 1151, and a work information update unit 1152; and
- a maintenance work remote operation control unit 1160.

The maintenance work control unit 1120 further includes a consumables replacement control unit 1121, a cleaning control unit 1122, and a state measurement control unit 1123.

The consumables replacement control unit 1121 is an example of a control unit and a determination unit. Upon receiving a maintenance work instruction from the remote monitoring apparatus 210, the consumables replacement control unit 1121 identifies the consumable article to be replaced based on the received maintenance work instruction. Furthermore, the consumables replacement control unit 1121 reads out the content of the operation of the work robot 220 or the stowable work robot 240_1 for replacing the identified consumable article from a maintenance work operation content storage unit 1126. The consumables replacement control unit 1121 outputs a control instruction to the drive controller 1012 such that the operation of the read-out content is performed under a replacement work parameter 1124. When outputting the control instruction, the consumables replacement control unit 1121 adjusts the control instruction to be output to the drive controller 1012 based on the sensor data acquired from the sensor data processing unit 1131.

Upon completing the consumables replacement, the consumables replacement control unit 1121 reads out the content of the operation of the work robot 220 or the stowable work robot 240_1 for measuring the work quality of the consumables replacement work from a work quality measurement operation content storage unit 1127. The consumables replacement control unit 1121 outputs a control instruction to the drive controller 1012 such that the operation of the read-out content is performed. When outputting the control instruction, the consumables replacement control unit 1121 adjusts the control instruction to be output to the drive controller 1012 based on the sensor data acquired from the sensor data processing unit 1131.

Upon acquiring a work quality measurement result from the work quality inspection unit 1132, the consumables replacement control unit 1121 determines whether or not the acquired measurement result satisfies a predetermined criterion. Furthermore, the consumables replacement control unit 1121 stores the measurement result in a work quality information storage unit 1144 in association with the replacement work parameter 1124.

When determining that the acquired measurement result does not satisfy the predetermined criterion, the consumables replacement control unit 1121 determines outputs an additional control instruction to the drive controller 1012 such that the measurement result to be acquired satisfies the predetermined criterion. The consumables replacement control unit 1121 outputs a control instruction to the drive controller 1012 until it determines that the acquired measurement result satisfies the predetermined criterion.

The cleaning control unit 1122 is another example of the control unit and the determination unit. Upon receiving a maintenance work instruction from the remote monitoring apparatus 210, the cleaning control unit 1122 identifies the chamber to be cleaned based on the received maintenance work instruction. Furthermore, the cleaning control unit 1122 reads out the content of the operation of the work robot 220 or the stowable work robot 240_1 for cleaning the identified chamber from the maintenance work operation content storage unit 1126. The cleaning control unit 1122 outputs a control instruction to the drive controller 1012 such that the operation of the read-out content is performed under a cleaning work parameter 1125. When outputting the control instruction, the cleaning control unit 1122 adjusts the control instruction to be output to the drive controller 1012 based on the sensor data acquired from the sensor data processing unit 1131.

When cleaning is completed, the cleaning control unit 1122 reads out the content of the operation of the work robot 220 or the stowable work robot 240_1 for measuring the work quality of the cleaning work from the work quality measurement operation content storage unit 1127. The cleaning control unit 1122 outputs a control instruction to the drive controller 1012 such that the operation of the read-out content is performed. When outputting the control instruction, the cleaning control unit 1122 adjusts the control instruction to be output to the drive controller 1012 based on the sensor data acquired from the sensor data processing unit 1131.

Upon acquiring a work quality measurement result from the work quality inspection unit 1132, the cleaning control unit 1122 determines whether or not the acquired measurement result satisfies a predetermined criterion. Furthermore, the cleaning control unit 1122 stores the measurement result in the work quality information storage unit 1144 in association with the cleaning work parameter 1125.

When determining that the acquired measurement result does not satisfy the predetermined criterion, the cleaning control unit 1122 outputs an additional control instruction to the drive controller 1012 such that the measurement result to be acquired satisfies the predetermined criterion. The cleaning control unit 1122 outputs the control instruction to the drive controller 1012 until it determines that the acquired measurement result satisfies the predetermined criterion.

Upon receiving a state measurement instruction from the remote monitoring apparatus 210, the state measurement control unit 1123 identifies a consumable article or a chamber for which the state measurement is to be performed, based on the received state measurement instruction. Furthermore, the state measurement control unit 1123 reads out the content of the operation of the stowable work robot 240_1 for performing the state measurement for the identified consumable article or chamber from a state measurement operation content storage unit 1128. The state measurement control unit 1123 outputs a control instruction to the drive controller 1012 such that the operation of the read-out content is performed. When outputting the control instruction, the state measurement control unit 1123 adjusts the control instruction to be output to the drive controller 1012 based on the sensor data acquired from the sensor data processing unit 1131.

The state measurement control unit 1123 calculates a state measurement result based on sensor data from the sensor data processing unit 1131 acquired by performing the state measurement for the identified consumable article or chamber, and transmits the calculated state measurement result to the remote monitoring apparatus 210.

The sensor data processing unit 1131 acquires sensor data from the sensor 1013 during consumables replacement, chamber cleaning, and consumables or chamber state measurement, and processes the acquired sensor data. The sensor data processing unit 1131 provides the processed sensor data to the maintenance work control unit 1120 as a notification.

The work quality inspection unit 1132 acquires sensor data from the sensor 1013 during consumables replacement or chamber cleaning, and measures the work quality based on the acquired sensor data. The work quality inspection unit 1132 provides the measured work quality to the maintenance work control unit 1120 as a notification.

The work quality training unit 1141 is an example of a first training unit. The work quality training unit 1141 performs re-training processing using a training data set including:
- a combination of a replacement work parameter 1124 and a work quality measurement result; or
- a combination of a cleaning work parameter 1125 and a work quality measurement result stored in the work quality information storage unit 1144.

The work parameter optimization unit 1142 is an example of a first optimization unit. The work parameter optimization unit 1142 searches for a work parameter under which a desired work quality can be achieved, by using a re-trained work quality prediction model generated by re-training processing being performed by the work quality training unit 1141. Thus, the work parameter optimization unit 1142 provides the searched-out work parameter to the parameter update unit 1143 as a notification.

The parameter update unit 1143 is an example of a first update unit. The parameter update unit 1143 updates the replacement work parameter 1124 or the cleaning work parameter 1125 with the work parameter (replacement work parameter or cleaning work parameter) provided as a notification from the work parameter optimization unit 1142. Thus, the work parameter after being updated, under which no additional operation is needed to satisfy the work quality, is set as the replacement work parameter 1124 or the cleaning work parameter 1125 in the maintenance work control unit 1120.

Every time the remote monitoring apparatus 210 issues a maintenance work instruction to the maintenance work control unit 1120, the work information collection unit 1151 transmits work information, in which the contents of operations read out from the maintenance work operation content storage unit 1126 are specified, to the remote monitoring apparatus 210.

The work information update unit 1152 is an example of a second update unit. The work information update unit 1152 receives work information, in which contents of operations that should be stored in the maintenance work operation content storage unit 1126 are specified, from the remote monitoring apparatus 210 as work information for update. The work information update unit 1152 stores the received work information for update in the maintenance work operation content storage unit 1126.

The maintenance work remote operation control unit 1160 operates when the work robot 220 or the stowable work robot 240_1 is malfunctioning and having difficulty performing autonomous control. Specifically, the maintenance work remote operation control unit 1160 transmits sensor data (for example, image data captured by the imaging devices 727, 820, 940 and 960) from the sensor data processing unit 1131 to the remote monitoring apparatus 210. The maintenance work remote operation control unit 1160 receives from the remote monitoring apparatus 210, operation information regarding a manual operation performed on the work robot 220 or the stowable work robot 240_1 by the remote monitoring person 250 of the remote monitoring apparatus 210 while viewing the transmitted image data. The maintenance work remote operation control unit 1160 also transmits the received operation information to the drive controller 1012.

Thus, the remote monitoring person 250 of the remote monitoring apparatus 210 can manually operate the work robot 220 or the stowable work robot 240_1 from a remote location.

### <Specific Example of Work Quality Information>

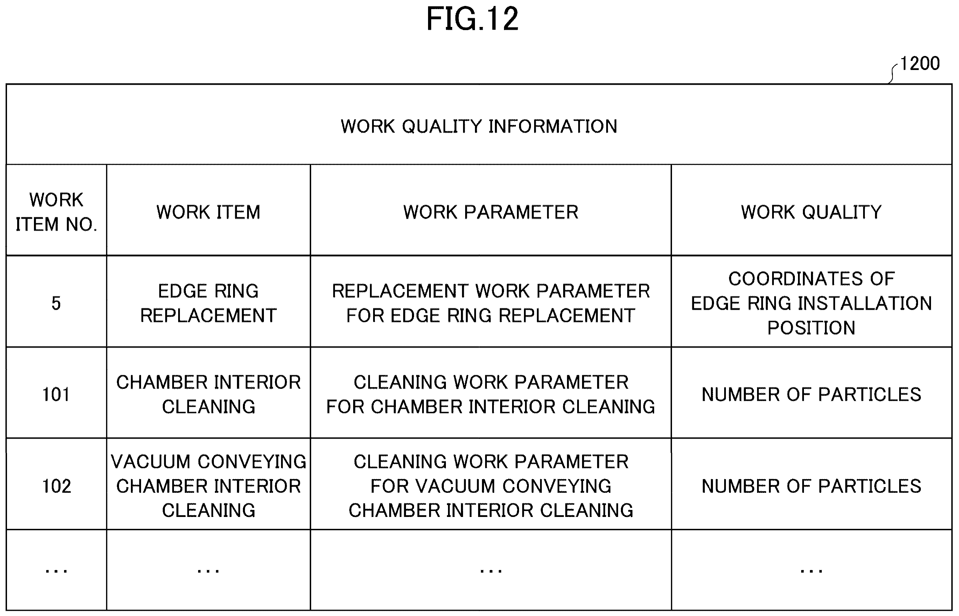

Next, a specific example of work quality information stored in the work quality information storage unit 1144 will be described. FIG. 12 is a diagram showing a specific example of the stored work quality information. As shown in FIG. 12, work quality information 1200 includes "work item number", "work item", "work parameter", and "work quality" as information items.

The "work item number" stores the work item number of maintenance work (see FIG. 3). The "work item" stores a work item involved in consumables replacement or cleaning.

The "work parameter" stores a replacement work parameter for each work item in the case of consumables replacement, and stores a cleaning work parameter for each work item in the case of cleaning.

The "work quality" stores a work quality measured by the work quality inspection unit 1132.

### <Details of Work Quality Training Unit>

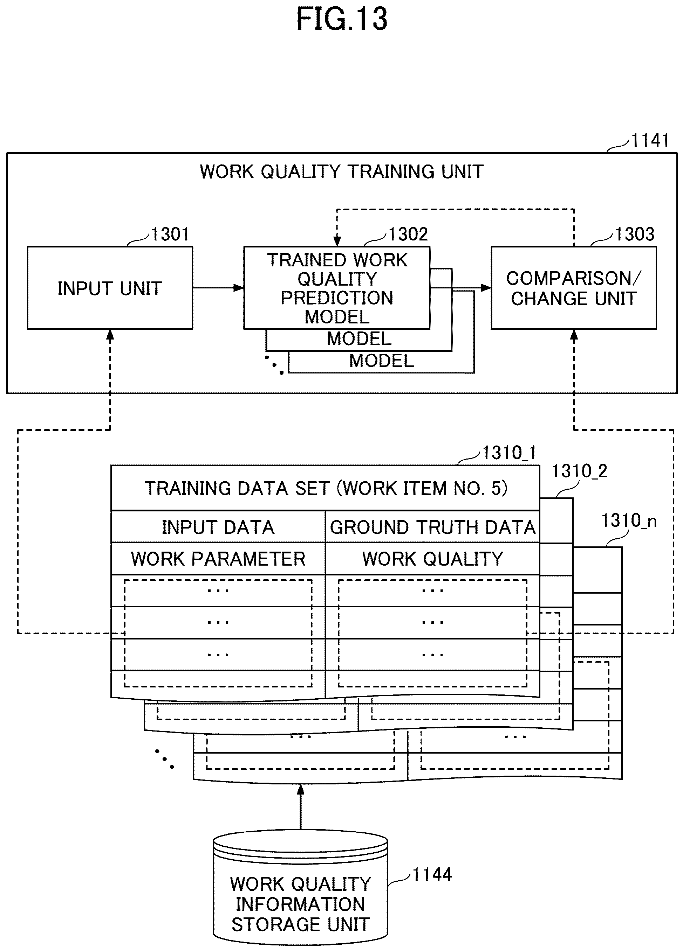

Next, details of the work quality training unit 1141 will be described. FIG. 13 is a diagram explaining details of the work quality training unit.

As shown in FIG. 13, the work quality training unit 1141 includes an input unit 1301, trained work quality prediction models 1302, and a comparison/change unit 1303. The work quality training unit 1141 performs re-training processing using training data sets 1310_1, 1310_2, ..., and 1310_n (an example of a first training data set) read out from the work quality information storage unit 1144.

As shown in FIG. 13, the training data sets 1310_1, 1310_2, ..., and 1310_n are read out separately per work item. The example of FIG. 13 shows that the training data set 1310_1 including the content of the operation of the work item number = 5 (edge ring replacement) as input data is read out as a training data set.

As shown in FIG. 13, the training data sets 1310_1, 1310_2, ..., and 1310_n each include "input data" and "ground truth data" as information items. For example, in the case of the training data set 1310_1, it is assumed that the "input data" and "ground truth data" include the replacement work parameters for edge ring replacement used in past maintenance work and the work quality measurement results in the work. Then, when maintenance work for the work item number = 5 (edge ring replacement) is newly completed, the training data set 1310_1 to which the replacement work parameter and the work quality measurement result in the instant work are added is read out.

The input unit 1301 reads out, for example, the training data set 1310_1 to which a replacement work parameter and a work quality measurement result are added as a result of maintenance work for the work item number = 5 having been newly completed. The "input data" of the read-out training data set 1310_1 are input into a corresponding trained work quality prediction model 1302.

The trained work quality prediction models 1302 include a number of trained work quality prediction models corresponding to the number of the training data sets (that is, the number of work items), and are configured to output output data in response to the "input data" of the training data sets being input by the input unit 1301. It is assumed that a trained work quality prediction model 1302 has been subjected to training processing using, for example, the training data set 1310_1, which is the training data set 1310_1 before addition of a replacement work parameter and a work quality measurement result.

The comparison/change unit 1303 compares the output data that is output from the trained work quality prediction model 1302 with the work qualities included in the "ground truth data" of the training data set, and updates the model parameter of the trained work quality prediction model 1302 in accordance with the error.

In this way, the work quality training unit 1141 performs re-training processing to generate a re-trained work quality prediction model (a model for predicting a work quality from a work parameter) for each work item.

### <Details of Work Parameter Optimization Unit>

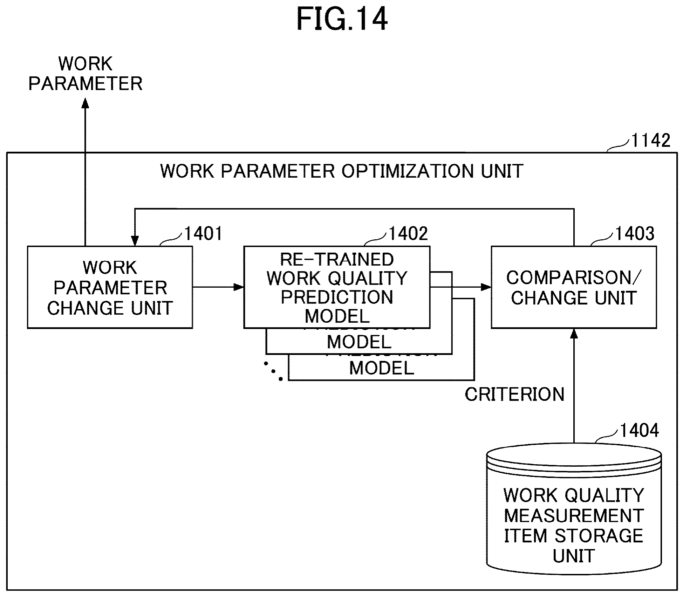

Next, details of the work parameter optimization unit 1142 will be described. FIG. 14 is a diagram explaining the details of the work parameter optimization unit.

As shown in FIG. 14, the work parameter optimization unit 1142 includes a work parameter change unit 1401, re-trained work quality prediction models 1402, and a comparison/change unit 1403. The work parameter optimization unit 1142 searches for an optimum work parameter for each work item.

The work parameter change unit 1401 exhaustively changes the replacement work parameters for each work item and inputs them into a corresponding re-trained work quality prediction model 1402. The replacement work parameters for each work item here refer to, for example, the replacement work parameters for edge ring replacement in the case where the work item is edge ring replacement (see FIG. 12). The work parameter change unit 1401 outputs, for each work item, the replacement work parameter, in response to which a work quality that is the closest to the criterion is predicted, among the replacement work parameters exhaustively changed for each work item.

Similarly, the work parameter change unit 1401 exhaustively changes the cleaning work parameters for each work item and inputs them into a corresponding re-trained work quality prediction model 1402. Here, the cleaning work parameters for each work item refer to, for example, the cleaning work parameters for chamber interior cleaning in the case where the work item is chamber interior cleaning (see FIG. 12). The work parameter change unit 1401 outputs, for each work item, the cleaning work parameter, in response to which a work quality that is the closest to the criterion is predicted, among the cleaning work parameters exhaustively changed for each work item.

The re-trained work quality prediction models 1402 are re-trained work quality prediction models generated for the respective work items by the work quality training unit 1141. The re-trained work quality prediction models 1402 predict work qualities when the replacement work parameters or cleaning work parameters are input by the work parameter change unit 1401.

The comparison/change unit 1403 compares the work quality output by the re-trained work quality prediction model 1402 with the criterion read out from a work quality measurement item storage unit 1404, and calculates an error. The comparison/change unit 1403 provides the calculated error to the work parameter change unit 1401 as a notification.

The work quality measurement item storage unit 1404 stores, for example, the work quality measurement items shown in FIG. 6, and the comparison/change unit 1403 reads out the criterion corresponding to the measurement item.

<Specific Example of Processing Performed by Work Information Collection Unit>

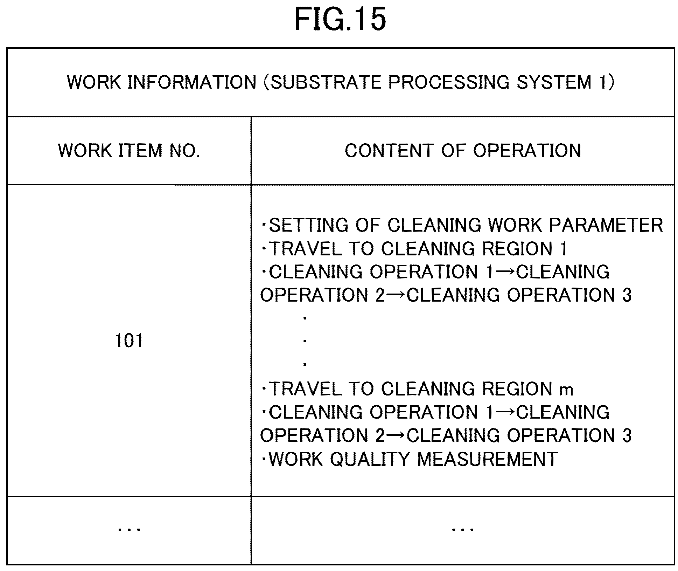

Next, as a specific example of processing performed by the work information collection unit 1151, work information acquired by the work information collection unit 1151 will be described. FIG. 15 is a diagram showing a specific example of processing performed by the work information collection unit. As described above, every time the remote monitoring apparatus 210 issues a maintenance work instruction, the work information collection unit 1151 reads out the content of an operation from the maintenance work operation content storage unit 1126 and transmits the content to the remote monitoring apparatus 210.

The example of FIG. 15 shows the content of an operation that is read out from the maintenance work operation content storage unit 1126 when the remote monitoring apparatus 210 issues a maintenance work instruction specifying a work item number = 101 (chamber interior cleaning in the etching apparatus).

In the example of FIG. 15, the stowable work robot 240_1 sequentially travels from a cleaning region 1 to a cleaning region m to perform a cleaning operation 1 → a cleaning operation 2 → a cleaning operation 3 in each cleaning region under a cleaning work parameter.

In the example of FIG. 15, the stowable work robot 240_1 measures the work qualities after the cleaning work in all of the cleaning regions has been completed, thereby completing the cleaning work for the work item number = 101.

Assume a case where the substrate quality measured by performing substrate processing on an inspection-target substrate W" at a start-up after the stowable work robot 240_1 has performed the operation of the content shown in the example of FIG. 15 has deteriorated due to aging or the like. In such a case, the remote monitoring apparatus 210 is trained about the content of the operation performed by the stowable work robot 240_1, and transmits work information for update to the stowable work robot 240_1. Thus, the content of the operation stored in the maintenance work operation content storage unit 1126 is updated to the content of the operation specified in the work information for update. The inspection-target substrate W" is, for example, a substrate on which a test pattern or a film formation process equivalent to that of a product substrate has been applied, and that is used for inspecting the behavior (quality) during an actual operation (in a state that is the same as when processing a product substrate).

Thus, for example, the content of the operation of the work item number = 101 shown in FIG. 15 is updated to the content of operation helpful for improving the substrate quality, such as a changed order for performing cleaning operations or a newly added cleaning operation.

### <Flow of Maintenance Work Support Processing Performed by Work Robot and Stowable work robot>

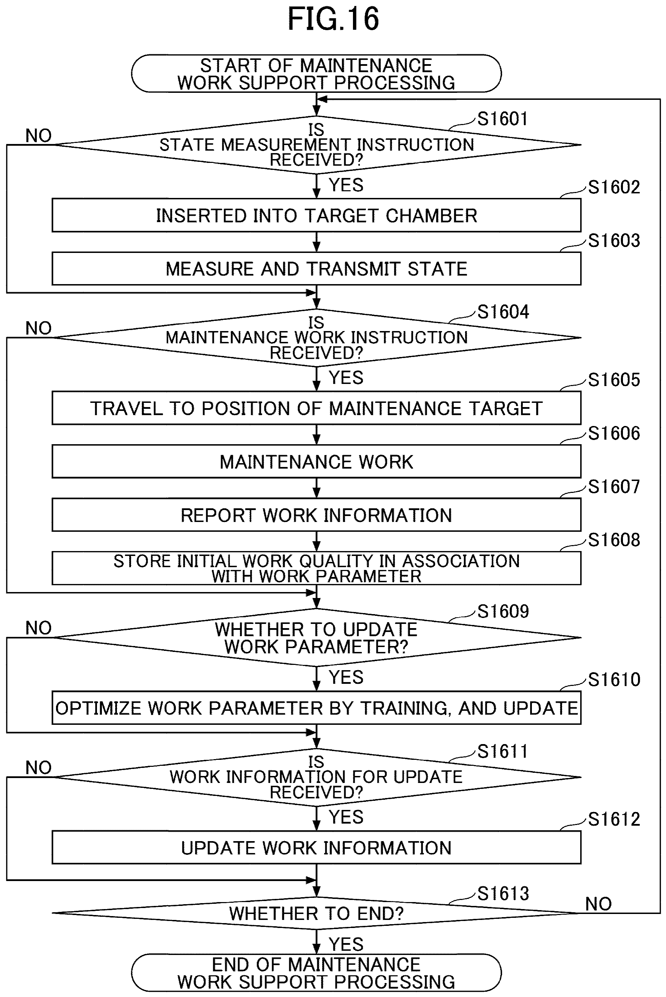

Next, the flow of the maintenance work support processing performed by the work robot 220 and the stowable work robot 240_1 will be described. FIG. 16 is a flowchart showing the flow of the maintenance work support processing performed by the work robot and the stowable work robot.

In step S1601, the stowable work robot 240_1 determines whether or not a state measurement instruction is received from the remote monitoring apparatus 210. When it is determined in step S1601 that no state measurement instruction is received (NO in step S1601), the process proceeds to step S1604.

On the other hand, when it is determined in step S1601 that a state measurement instruction is received (YES in step S1601), the process proceeds to step S1602.

In step S1602, the robot arm 470 connects to the stowable work robot 240_1, to insert the stowable work robot 240_1 into the chamber of the processing apparatus that is the target apparatus.

In step S1603, the stowable work robot 240_1 performs state measurement on a consumable article or the chamber. In addition, the stowable work robot 240_1 transmits the state measurement result to the remote monitoring apparatus 210.

In step S1604, the work robot 220 or the stowable work robot 240_1 determines whether or not a maintenance work instruction is received from the remote monitoring apparatus 210. When it is determined in step S1604 that no maintenance work instruction is received (NO in step S1604), the process proceeds to step S1609.

On the other hand, when it is determined in step S1604 that a maintenance work instruction is received, the process proceeds to step S1605.

In step S1605, the work robot 220 travels to the position of the target system. Alternatively, the robot arm 470 connects to the stowable work robot 240_1, and inserts the stowable work robot 240_1 into the chamber of the processing apparatus that is the target apparatus.

In step S1606, the work robot 220 or the stowable work robot 240_1 performs a maintenance work (consumables replacement or cleaning). In addition, the work robot 220 or the stowable work robot 240_1 measures the work quality and continues additional operations until the work quality satisfies the predetermined criterion. When the work quality satisfies the predetermined criterion, the work robot 220 or the stowable work robot 240_1 ends the maintenance work.

In step S1607, the work robot 220 or the stowable work robot 240_1 transmits work information in which the content of the operation of the maintenance work is specified to the remote monitoring apparatus 210.

In step S1608, the work robot 220 or the stowable work robot 240_1 stores the work quality measured at the first work quality measurement as work quality information in association with the work parameter.

In step S1609, the work robot 220 or the stowable work robot 240_1 determines whether or not to update the work parameter. When it is determined in step S1609 to not update the work parameter (NO in step S1609), the process proceeds to step S1611.

On the other hand, when it is determined in step S1609 to update the work parameter (YES in step S1609), the process proceeds to step S1610.

In step S1610, the work robot 220 or the stowable work robot 240_1 performs re-training processing on the trained work quality prediction model using the training data set, and generates a re-trained work quality prediction model. In addition, the work robot 220 or the stowable work robot 240_1 searches for an optimum work parameter for each work item using the generated re-trained work quality prediction model.

In step S1611, the work robot 220 or the stowable work robot 240_1 determines whether or not work information for update is received from the remote monitoring apparatus 210. When it is determined in step S1611 that no work information for update is received (NO in step S1611), the process proceeds to step S1613.

On the other hand, when it is determined in step S1611 that work information for update is received (YES in step S1611), the process proceeds to step S1612.

In step S1612, the work robot 220 or the stowable work robot 240_1 stores the received work information for update in the maintenance work operation content storage unit 1126.

In step S1613, the work robot 220 or the stowable work robot 240_1 determines whether or not to end the maintenance work support processing. When it is determined in step S1613 to continue the maintenance work support processing (NO in step S1613), the process returns to step S1601.

On the other hand, when it is determined in step S1613 to end the maintenance work support processing (YES in step S1613), the maintenance work support processing is ended.

### <Details of Conveying Robot>

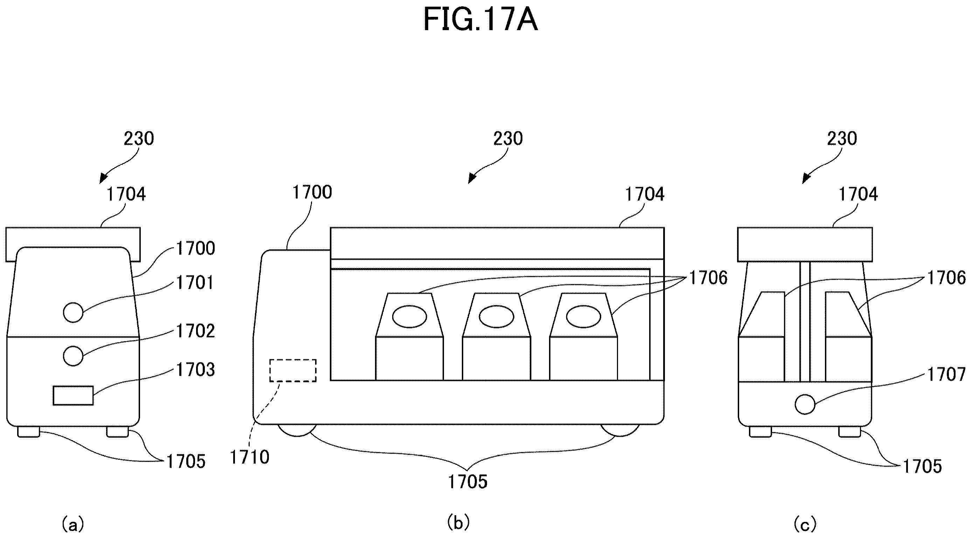

Next, details of the conveying robot 230 will be described. FIG. 17A is a view showing an example of the conveying robot, and (a) shows the conveying robot 230 viewed from the front, (b) shows the conveying robot 230 viewed from a side, and (c) shows the conveying robot 230 viewed from the rear.

As shown in FIG. 17A (a), the conveying robot 230 includes a main body 1700. Imaging devices 1701 and 1702 are provided on the front surface of the main body 1700 to capture RGB image data and depth image data, respectively. A laser device 1703 is also provided on the front surface of the main body 1700 to measure the distance to, for example, an obstacle. Further, a conveying table 1704, on which consumables among the parts required for the maintenance work are mainly mounted, is provided on top of the main body 1700. Further, a travelling part 1705 for moving the conveying robot 230 is provided under the main body 1700.

As shown in FIG. 17A (b), when viewed from a side, the main body 1700 is structured in two tiers, and the conveying table 1704 is provided in the upper tier, and six end effector exchangers 1706 are provided in the lower tier. However, the number of end effector exchangers 1706 is not limited to six.

One of the six end effector exchangers 1706 serves to detach the end effector 740 from the tip of the first arm of the work robot 220 when the tip is inserted into an opening. The remaining five serve to attach the end effector 740 to the tip of the first arm of the work robot 220 when the tip is inserted into the opening in a state in which the end effector 740 is detached.

The main body 1700 also includes a controller 1710 and outputs control instructions for controlling the travelling part 1705 and the end effector exchangers 1706. The controller 1710 also communicates with the remote monitoring apparatus 210 to receive a maintenance work instruction from the remote monitoring apparatus 210, and communicates with the work robot 220 to perform cooperative control with the work robot 220.

As shown in FIG. 17A (c), the end effector exchangers 1706 are provided on the right side surface and the left side surface of the main body 1700. An imaging device 1707 is provided on the rear surface of the main body 1700 to capture RGB image data.

### <Example of Operation of Conveying Robot>

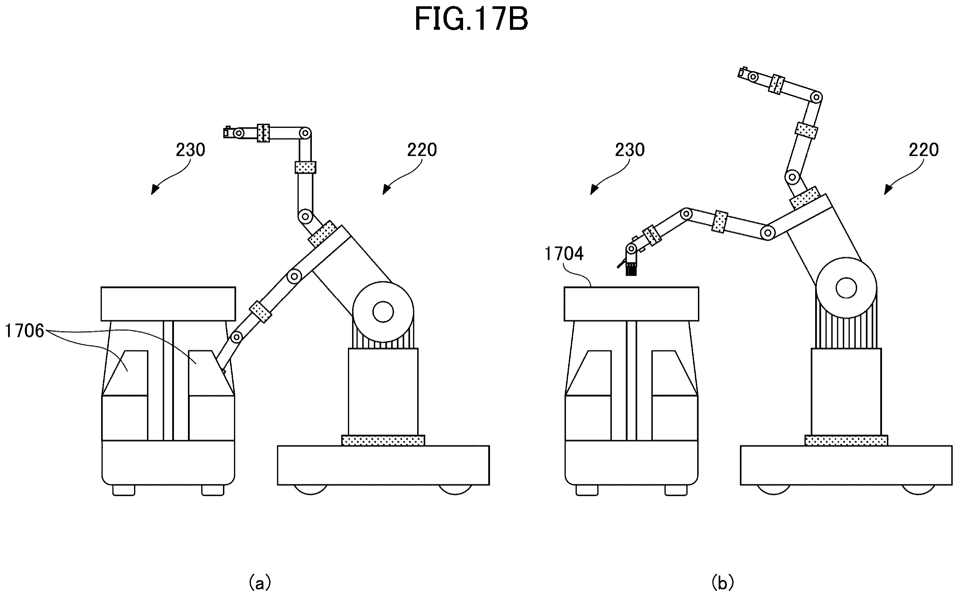

Next, an example of the operation of the conveying robot 230 will be described. FIG. 17B is a view showing an example of the operation of the conveying robot.

As shown in FIG. 17B (a), upon receiving a maintenance work instruction, the conveying robot 230 travels to the vicinity of the work robot 220 and provides the end effector 740 that is suitable for the maintenance work. FIG. 17B (a) shows a state in which the end effector 740 is being attached by the tip of the first arm of the work robot 220 being inserted into the end effector exchanger 1706. Thus, as maintenance work, the work robot 220 can perform, for example, edge ring replacement by using an end effector suitable for detaching the edge ring 514 and attaching a new edge ring 514'.

As shown in FIG. 17B (b), during the maintenance work performed by the work robot 220, the conveying robot 230 is positioned near the work robot 220 and receives the detached consumable article (for example, the edge ring 514). The conveying robot 230 provides a new edge ring 514' to the work robot 220. The edge ring 514 received from the work robot 220 and the edge ring 514' provided to the work robot 220 are mounted on the conveying table 1704.

### <Specific Examples of Parts Provided by Conveying Robot>

Next, specific examples of parts provided by the conveying robot 230 and required when the work robot 220 and the stowable work robot 240_1 perform maintenance work will be described.

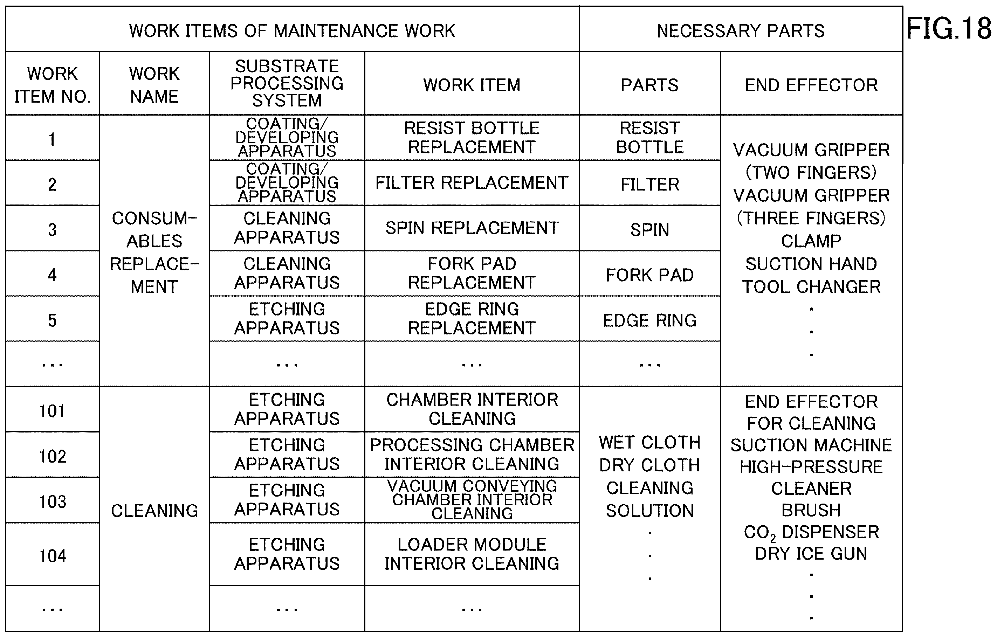

FIG. 18 is a view showing specific examples of parts provided by the conveying robot. As shown in FIG. 18, for example, in a case of consumables replacement in a coating/developing apparatus, the conveying robot 230 provides a resist bottle when the work item is replacement of resist bottles, and the conveying robot 230 provides a filter when the work item is replacement of filters.

For example, in a case of consumables replacement in a cleaning apparatus, the conveying robot 230 provides a spin when the work item is replacement of spins, and the conveying robot 230 provides a fork pad when the work item is replacement of fork pads,

For example, in a case of consumables replacement in an etching apparatus, the conveying robot 230 provides an edge ring when the work item is replacement of edge rings.

Examples of the end effectors provided by the conveying robot 230 for consumables replacement include a vacuum gripper (two fingers), a vacuum gripper (three fingers), a clamp, a suction hand, a tool changer, and the like.

For example, in a case of cleaning in an etching apparatus, the conveying robot 230 provides a wet cloth, a dry cloth, a cleaning solution, and the like when the work item is chamber interior cleaning, vacuum conveying chamber interior cleaning, and loader module interior cleaning.

Example of the end effectors provided by the conveying robot 230 for cleaning include an end effector for cleaning, a suction machine, a highpressure cleaner, a brush, a CO2 dispenser, a dry ice gun, and the like.

### <Hardware Configuration of Controller of Conveying Robot >

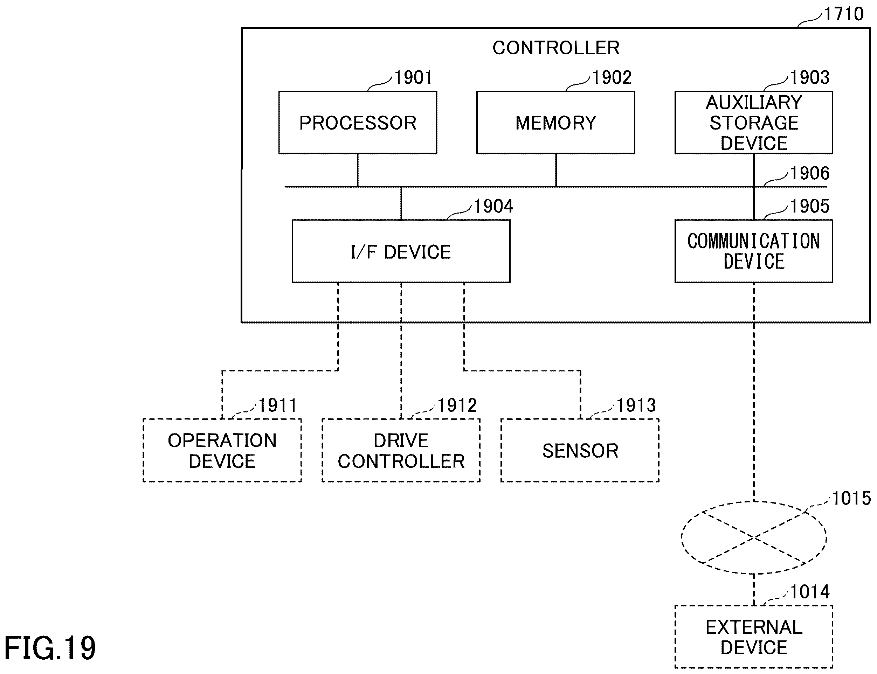

Next, the hardware configuration of a controller 1710 of the conveying robot 230 will be described. FIG. 19 is a diagram showing an example of the hardware configuration of the controller of the conveying robot.

As shown in FIG. 19, the controller 1710 includes a processor 1901, a memory 1902, an auxiliary storage device 1903, an interface (I/F) device 1904, and a communication device 1905. The hardware components included in the controller 1710 are connected to each other via a bus 1906.

Since the hardware components of the controller 1710 are generally the same as the hardware components of the controller 703 of the work robot 220 and the controller 793 of the stowable work robot 240_1 described with reference to FIG. 10, the following description will focus on the differences.

The I/F device 1904 is a connection device for connecting to external devices (an operation device 1911, a drive controller 1912, a sensor 1913, and the like). The I/F device 1904 receives a worker's operation on the conveying robot 230 via the operation device 1911. The operation device 1911 includes an operation switch for turning ON/OFF the power source of the conveying robot 230, an operation switch for emergency stop, and the like.

The I/F device 1904 outputs a control instruction from the controller 1710 to the drive controller 1912. The drive controller 1912 includes a device that outputs an operation signal for controlling travelling of the conveying robot 230 and the operation of the end effector exchangers 1706.

The I/F device 1904 receives sensor data from the sensor 1913. The sensor 1913 includes various sensors of the conveying robot 230, such as sensors of the imaging devices 1701, 1702, and 1707, the laser device 1703, and the end effector exchangers 1706.

### <Functional Configuration of Controller of Conveying Robot>

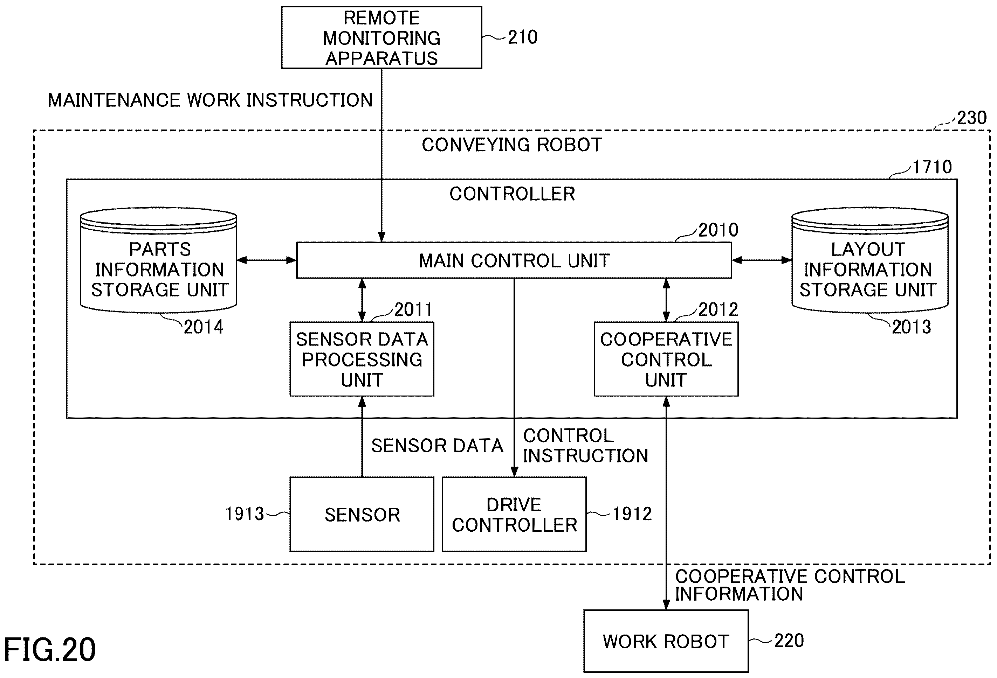

Next, the functional configuration of the controller 1710 of the conveying robot 230 will be described. FIG. 20 is a diagram showing an example of the functional configuration of the controller of the conveying robot. A control program is installed in the controller 1710 of the conveying robot 230, and when the program is executed, the controller 1710 functions as a main control unit 2010, a sensor data processing unit 2011, and a cooperative control unit 2012.

Upon receiving a maintenance work instruction from the remote monitoring apparatus 210, the main control unit 2010 identifies the target system and the work item of the maintenance work, and acquires the current position/posture information of the work robot 220 from the sensor data processing unit 2011.

The main control unit 2010 reads out layout information indicating the layout in the substrate manufacturing factory 120 stored in the layout information storage unit 2013, and derives a travelling path to the storage location where the parts necessary for the maintenance work of the identified work item are stored based, on the current position/posture information. The main control unit 2010 outputs a control instruction to the drive controller 1912 based on the current position/posture information during travelling such that the travelling is performed in accordance with the derived travelling path. Thus, the parts necessary for the maintenance work are mounted on the conveying robot 230. The main control unit 2010 determines the parts necessary for the maintenance work of the identified work item by referring to parts information (for example, the information shown in FIG. 18) stored in a parts information storage unit 2014.

The main control unit 2010 reads out the layout information indicating the layout in the substrate manufacturing factory 120 stored in the layout information storage unit 2013, and derives a travelling path to the identified target system based on the current position/posture information. Furthermore, the main control unit 2010 outputs a control instruction to the drive controller 1912 based on the current position/posture information during travelling such that the travelling is performed in accordance with the derived travelling path. Thus, the conveying robot 230 mounted with the parts necessary for the maintenance work travels to the target system, and can provide the parts to the work robot 220 in the vicinity of the work robot 220.

When the maintenance work performed by the work robot 220 is completed, the main control unit 2010 reads out the layout information indicating the layout in the substrate manufacturing factory 120 stored in the layout information storage unit 2013. Furthermore, the main control unit 2010 derives a travelling path to a disposal location where the parts that have become unnecessary as a result of the maintenance work are disposed of based on the read-out layout information and the current position/posture information. The main control unit 2010 outputs a control instruction to the drive controller 1912 based on the current position/posture information during travelling such that the travelling is performed in accordance with the derived travelling path. Thus, the parts that have become unnecessary as a result of the maintenance work can be disposed of.

During travelling in accordance with the travelling moving path, the main control unit 2010 acquires the current position/posture information from the sensor data processing unit 2011, and when obstacle information is acquired, adjusts the control instruction to be output to the drive controller 1912 based on the acquired obstacle information.

The main control unit 2010 exchanges cooperative control information with the work robot 220 via the cooperative control unit 2012. As described above, the cooperative control information is instruction information for efficiently performing the maintenance work, and includes an instruction from the conveying robot 230 to the work robot 220 and an instruction from the work robot 220 to the conveying robot 230.

The cooperative control unit 2012 transmits cooperative control information output from the main control unit 2010 to the work robot 220, and provides cooperative control information transmitted from the work robot 220 to the main control unit 2010 as a notification.

### <Specific Example of Processing Performed by Cooperative Control Unit>

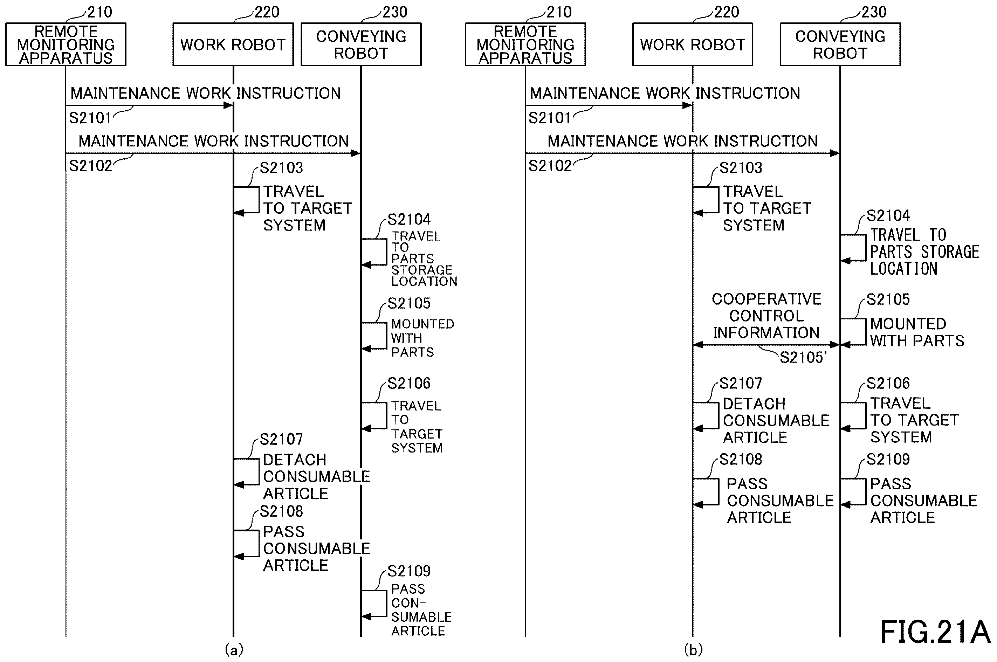

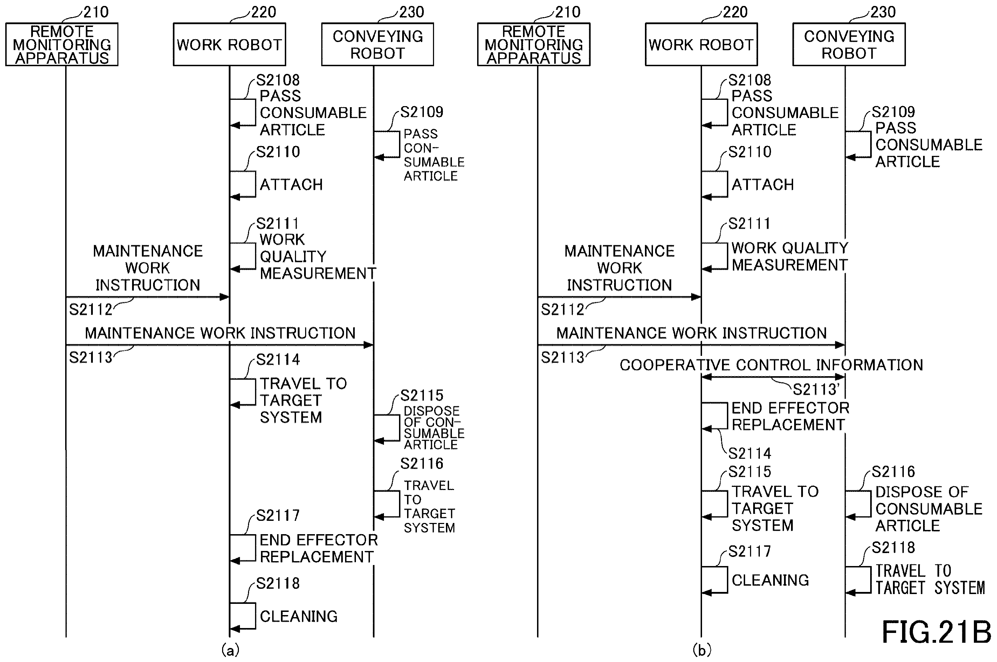

Next, a specific example of processing performed by the cooperative control unit 2012 will be described. FIGS. 21A and 21B are first and second diagrams showing specific examples of processing performed by the cooperative control unit. FIGS. 21A and 21B also show specific examples of processing for when the processing to be performed by the cooperative control unit 2012 is not performed, in order to clarify the advantage of performing the processing to be performed by the cooperative control unit 2012.

### (1) Specific Example 1

FIG. 21A (a) shows a specific example of processing, which is processing for when the processing to be performed by the cooperative control unit 2012 is not performed, and is processing from transmission of a maintenance work instruction to passing of consumable articles.

In steps S2101 and S2102, the remote monitoring apparatus 210 transmits to the work robot 220 and the conveying robot 230, a maintenance work instruction that explicitly specifies the target system for which the maintenance work should be performed and the work items.

In step S2103, the work robot 220 travels to the target system.

In step S2104, the conveying robot 230 travels to the parts storage location where the parts necessary for the maintenance work are stored.

In step S2105, the conveying robot 230 is mounted with the parts at the parts storage location.

In step S2106, the conveying robot 230 travels to the target system.

In step S2107, the work robot 220 detaches the consumable article in the target system.

In step S2108, the work robot 220 unloads the detached consumable article, mounts it on the conveying robot 230, and receives the consumable article to be newly attached from the conveying robot 230.

In step S2109, the conveying robot 230 receives the detached consumable article from the work robot 220, and passes the consumable article to be newly attached to the work robot 220.

Meanwhile, FIG. 21A (b) shows a specific example of processing, which is processing for when processing to be performed by the cooperative control unit 2012 is performed, and is processing from transmission of a maintenance work instruction to passing of consumable articles. The difference from FIG. 21A (a) lies in step S2105' and subsequent steps.

In step S2105', the conveying robot 230 transmits to the work robot 220, the completion of mounting of parts and the time to arrive at the target system as cooperative control information. Thus, the work robot 220 determines that if detachment of the consumable article is started immediately, the conveying robot 230 will arrive at the vicinity of the work robot 220 by the completion of detachment and unloading.

Therefore, in the case of FIG. 21A (b), travel of the conveying robot 230 to the target system in step S2106 and detachment of the consumable article by the work robot 220 in step S2107 are performed in parallel.

Thus, it is possible to bring efficiency to the maintenance work by exchanging cooperative control information between the work robot 220 and the conveying robot 230.

### (2) Specific Example 2

FIG. 21B (a) shows a specific example of processing, which is processing for when processing to be performed by the cooperative control unit 2012 is not performed, and is processing from passing of consumable articles to the next maintenance work.

In step S2108, the work robot 220 mounts the detached consumable article on the conveying robot 230 and receives the consumable article to be newly attached from the conveying robot 230.

In step S2109, the conveying robot 230 receives the detached consumable article from the work robot 220 and passes the consumable article to be newly attached to the work robot 220.

In step S2110, the work robot 220 attaches the consumable article to be newly attached, to the target system.

In step S2111, the work robot 220 measures the work quality.

In steps S2112 and S2113, the remote monitoring apparatus 210 transmits to the work robot 220 and the conveying robot 230, a maintenance work instruction that explicitly specifies the target system for which maintenance work should be performed next and the work item.

In step S2114, the work robot 220 travels to the target system.

In step S2115, the conveying robot 230 conveys the detached consumable article to the disposal location and disposes of it.

In step S2116, the conveying robot 230 travels to the target system. It is assumed that the conveying robot 230 has already been mounted with the parts necessary for the maintenance work for the work item specified in the maintenance work instruction received in step S2113.

In step S2117, the work robot 220 replaces the current end effector (here, an end effector suitable for replacing consumable articles) with an end effector (here, an end effector suitable for cleaning) conveyed by the conveying robot 230.

In step S2118, the work robot 220 performs cleaning.

Meanwhile, FIG. 21B (b) shows a specific example of processing, which is processing for when processing to be performed by the cooperative control unit 2012 is performed, and is processing from transmission of a maintenance work instruction to passing of consumable articles. The difference from FIG. 21B (a) lies in step S2113' and subsequent steps.

In step S2113, as cooperative control information, the conveying robot 230 notifies the work robot 220 that it has already been mounted with the parts necessary for the maintenance work for the work item specified in the maintenance work instruction received in step S2113. Thus, the work robot 220 determines that it can replace end effectors before travelling to the next target system.

Therefore, in the case of FIG. 21B (b), in step S2114, the work robot 220 replaces the current end effector (an end effector suitable for replacing consumable articles) with an end effector an (end effector suitable for cleaning) mounted on the conveying robot 230.

In step S2115, the work robot 220 travels to the target system.

In step S2116, the conveying robot 230 conveys the detached consumable article to the disposal location and disposes of it.

In step S2117, the work robot 220 performs cleaning.

In step S2118, the conveying robot 230 moves to the target system.

Thus, by exchanging the end effectors earlier, the work robot 220 can perform the next maintenance work without waiting for the conveying robot 230 to arrive at the target system.

In other words, it is possible to bring efficiency to the maintenance work by exchanging cooperative control information between the work robot 220 and the conveying robot 230.

### <Flow of Maintenance Work Support Processing Performed by Conveying Robot>

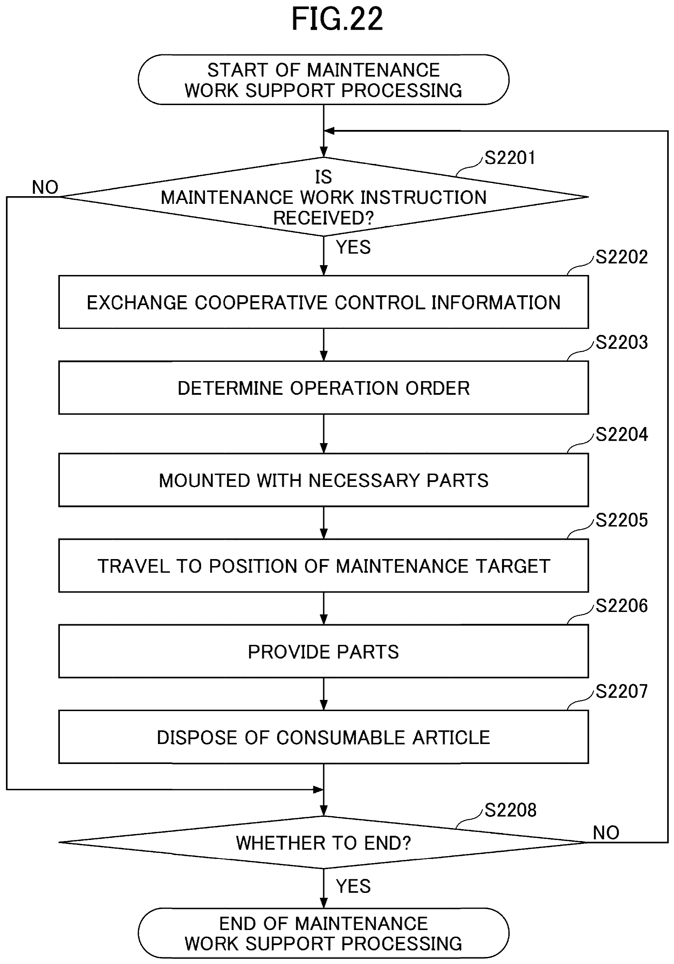

Next, the flow of the maintenance work support processing performed by the conveying robot 230 will be described. FIG. 22 is a flowchart showing the flow of the maintenance work support processing performed by the conveying robot.

In step S2201, the conveying robot 230 determines whether or not a maintenance work instruction is received from the remote monitoring apparatus 210. When it is determined in step S2201 that no maintenance work instruction is received (NO in step S2201), the process proceeds to step S2208.

On the other hand, when it is determined in step S2201 that a maintenance work instruction is received (YES in step S2201), the process proceeds to step S2202.

In step S2202, the conveying robot 230 exchanges cooperative control information with the work robot 220.

In step S2203, the conveying robot 230 determines an operation order based on the cooperative control information exchanged with the work robot 220. Hereinafter, in steps S2204 to S2207, processing is performed according to the operation order determined in step S2203, and an example of a determined operation order will be described here.

In step S2204, the conveying robot 230 travels to the storage location of the parts necessary for the maintenance work for the work item specified in the maintenance work instruction received in step S2201, and is mounted with the necessary parts.

In step S2205, the conveying robot 230 travels to the position of the target system specified in the maintenance work instruction received in step S2201.

In step S2206, the conveying robot 230 provides the necessary parts to the work robot 220.

In step S2207, the conveying robot 230 receives the consumable article from the work robot 220, conveys the received consumable article to the disposal location, and disposes of it.

In step S2208, the conveying robot 230 determines whether or not to end the maintenance work support processing. When it is determined in step S2208 to continue the maintenance work support processing (NO in step S2208), the process returns to step S2201.

On the other hand, when it is determined in step S2208 to end the maintenance work support processing (YES in step S2208), the maintenance work support processing is ended.

### <Details of Remote Monitoring Apparatus>

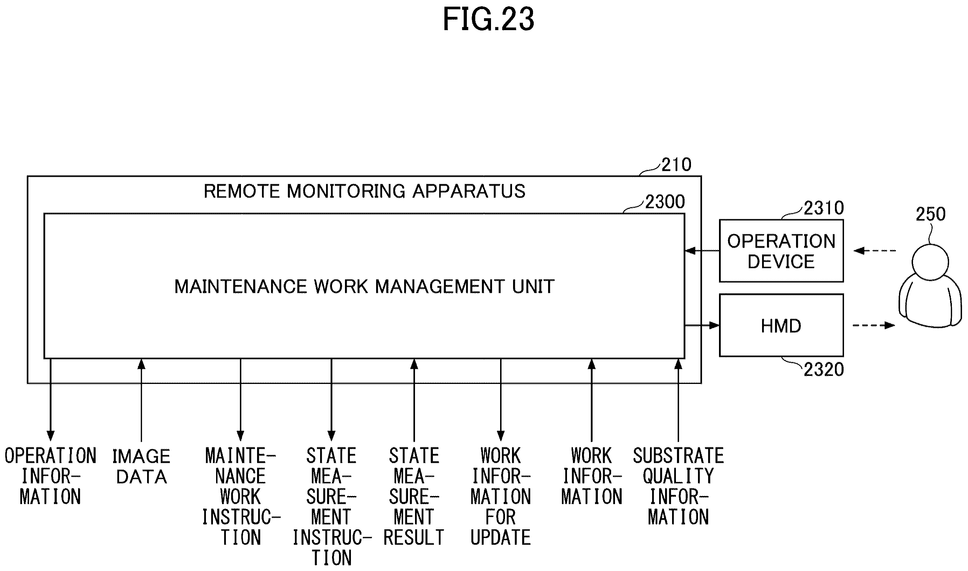

Next, details of the remote monitoring apparatus 210 will be described. FIG. 23 is a diagram showing an example of the remote monitoring apparatus. A maintenance work management program is installed in the remote monitoring apparatus 210, and when the program is executed, the remote monitoring apparatus 210 functions as a maintenance work management unit 2300.

The maintenance work management unit 2300 transmits a state measurement instruction to the stowable work robot 240_1 during a substrate processing period. The maintenance work management unit 2300 acquires a state measurement result from the stowable work robot 240_1, determines whether or not maintenance work is necessary in the target system, and determines a maintenance schedule.

After entering a maintenance period, the maintenance work management unit 2300 transmits a maintenance work instruction to the work robot 220, the stowable work robot 240_1, and the conveying robot 230.

The maintenance work management unit 2300 acquires work information that specifies the content of the operation that is read out from the maintenance work operation content storage unit 1126 every time the work robot 220 or the stowable work robot 240_1 performs maintenance work.

The maintenance work management unit 2300 acquires substrate quality information about an inspection-target substrate W" that is processed by the substrate processing system 121 at a start-up after the work robot 220 or the stowable work robot 240_1 has performed maintenance work. The inspection-target substrate W" processed by the substrate processing system 121 is inspected by the substrate quality inspection apparatus, and the maintenance work management unit 2300 acquires the substrate quality information from the substrate quality inspection apparatus.

The maintenance work management unit 2300 searches for an optimum content of an operation based on the acquired work information and the acquired substrate quality information, and transmits work information for update in which the searched-out content of an operation is specified to the work robot 220 or the stowable work robot 240_1. Thus, the work robot 220 or the stowable work robot 240_1 can perform maintenance work based on the work information for update in which the optimum content of an operation is specified.

The maintenance work management unit 2300 acquires image data from the work robot 220 or the stowable work robot 240_1 when a failure occurs in the work robot 220 or the stowable work robot 240_1. The maintenance work management unit 2300 transmits the acquired image data to a Head Mounted Display (HMD, an example of a display device) used by the remote monitoring person 250 for viewing the image data, to display the image data to the remote monitoring person 250. The maintenance work management unit 2300 acquires an operation instruction performed on an operation device 2310 by the remote monitoring person 250 while viewing the displayed image data, and transmits the operation instruction to the work robot 220 or the stowable work robot 240_1 as operation information. Thus, even when a failure occurs in the work robot 220 or the stowable work robot 240_1, the work robot 220 or the stowable work robot 240_1 can be operated by remote operations performed by the remote monitoring person 250.

### <Hardware Configuration of Remote Monitoring Apparatus>

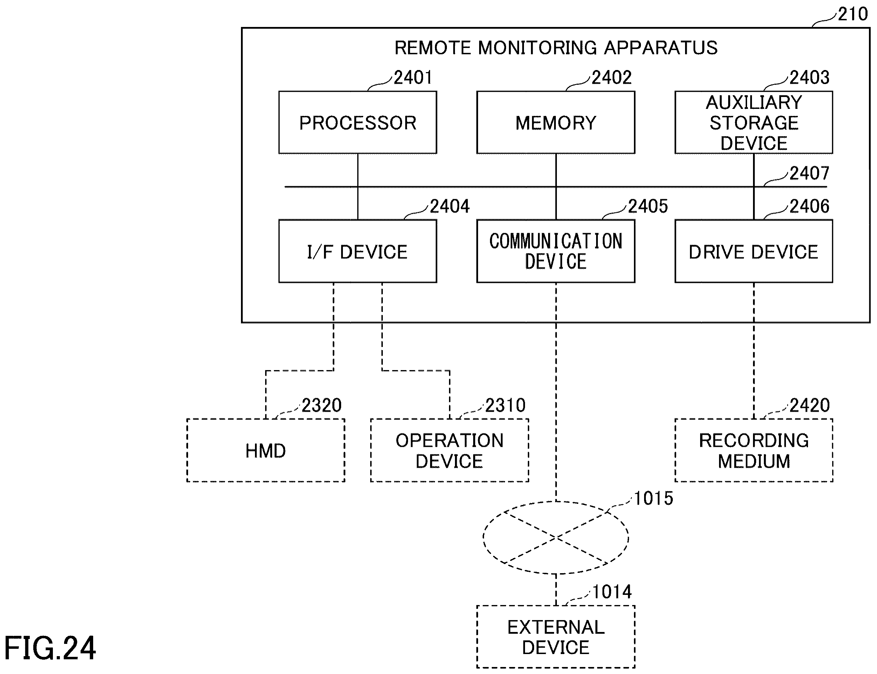

Next, the hardware configuration of the remote monitoring apparatus 210 will be described. FIG. 24 is a diagram showing an example of the hardware configuration of the remote monitoring apparatus.

As shown in FIG. 24, the remote monitoring apparatus 210 includes a processor 2401, a memory 2402, an auxiliary storage device 2403, an interface (I/F) device 2404, a communication device 2405, and a drive device 2406. The hardware components included in the remote monitoring apparatus 210 are connected to each other via a bus 2407.

Since the hardware components of the remote monitoring apparatus 210 are generally the same as the hardware components of the controller 703 of the work robot 220 and the hardware components of the controller 793 of the stowable work robot 240_1 described with reference to FIG. 10, the following description will focus on the differences.

The I/F device 2404 is a connection device for connecting to external devices (an HMD 232, and an operation device 2310).

The drive device 2406 is a device in which a recording medium 2420 is set. Examples of the recording medium 2420 include media for recording information optically, electrically, or magnetically, such as a CD-ROM, a flexible disk, a magneto-optical disk, and the like. Examples of the recording medium 2420 may also include a semiconductor memory and the like for recording information electrically, such as a ROM, a flash memory, and the like.

Various programs to be installed in the auxiliary storage device 2403 are installed by a distributed recording medium 2420 being set in the drive device 2406, and various programs recorded in the recording medium 2420 being read out by the drive device 2406. Alternatively, various programs to be installed in the auxiliary storage device 2403 may be installed by being downloaded from the network 1015 via a communication device 2405.

<Details of Maintenance Work Management Unit>

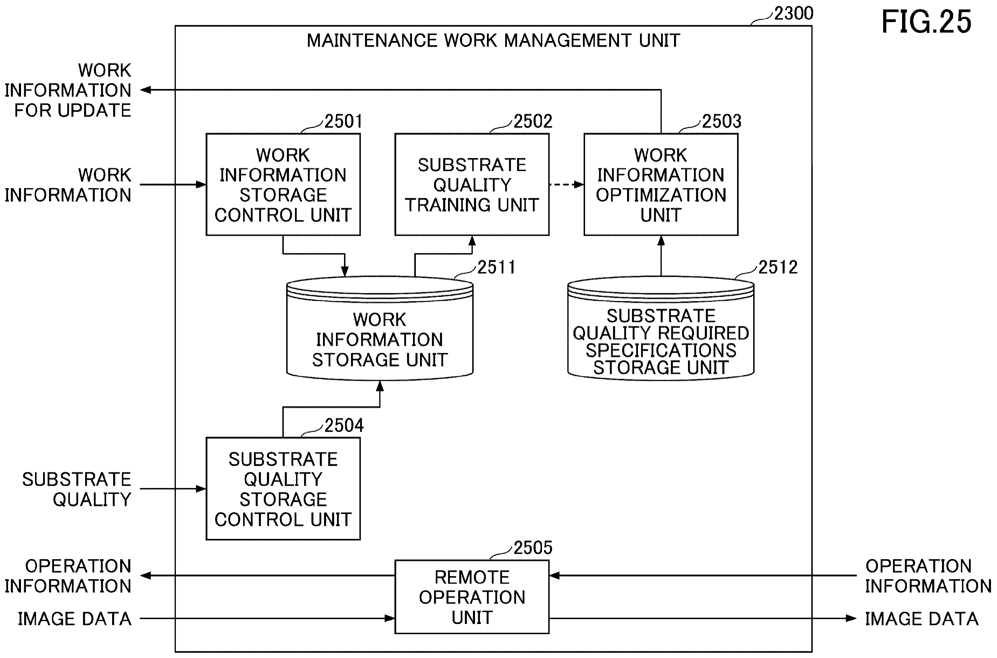

Next, among the functions of the maintenance work management unit 2300, a function for outputting work information for update and a function related to remote operations will be described in detail. FIG. 25 is a diagram explaining the details of the maintenance work management unit. As shown in FIG. 25, the maintenance work management unit 2300 includes a work information storage control unit 2501, a substrate quality training unit 2502, a work information optimization unit 2503, a substrate quality storage control unit 2504, and a remote operation unit 2505.

The work information storage control unit 2501 acquires work information transmitted from the work robot 220 or the stowable work robot 240_1 every time maintenance work is performed, and stores the work information in a work information storage unit 2511.

The substrate quality storage control unit 2504 acquires substrate quality information from the substrate quality inspection apparatus at a start-up after maintenance work, and stores the substrate quality information in the work information storage unit 2511 in association with the work information.

The substrate quality training unit 2502 is an example of a second training unit. The substrate quality training unit 2502 performs re-training processing on a trained substrate quality prediction model using a training data set including a combination of work information and substrate quality information stored in the work information storage unit 2511, and generates a re-trained substrate quality prediction model.

The work information optimization unit 2503 is an example of a second optimization unit. The work information optimization unit 2503 inputs the contents of operations of the work robot 220 and the stowable work robot 240_1 exhaustively into the re-trained substrate quality prediction model for each work item, and predicts substrate qualities to be achieved when the work robots are operated based on the respective contents of operations. The work information optimization unit 2503 reads out required specifications of the substrate quality from a substrate quality required specifications storage unit 2512, and searches for the optimum content of an operation by finding a substrate quality satisfying the required specifications from among the predicted substrate qualities. Furthermore, the work information optimization unit 2503 transmits work information for update in which the searched-out optimum content of an operation is specified to the work robot 220 or the stowable work robot 240_1.

When a failure occurs in the work robot 220 or the stowable work robot 240_1, the remote operation unit 2505 acquires image data from the work robot 220 or the stowable work robot 240_1 and transmits it to the HMD worn by the remote monitoring person 250. The remote operation unit 2505 acquires operation information from the operation device 2310 operated by the remote monitoring person 250 and transmits it to the work robot 220 or the stowable work robot 240_1.

### <Details of Substrate Quality Training Unit>

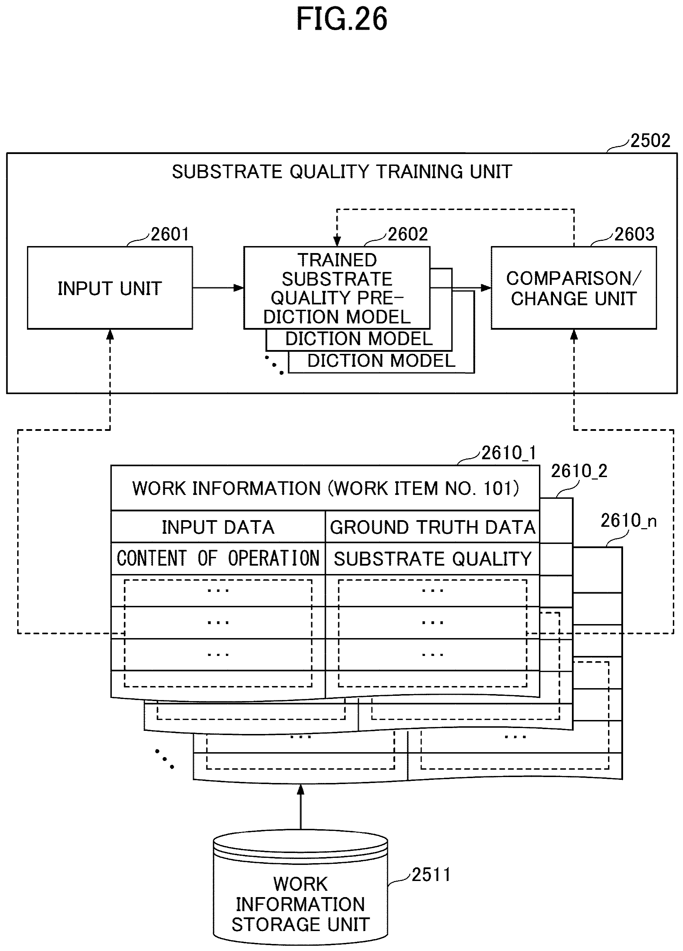

Next, details of the substrate quality training unit 2502 will be described. FIG. 26 is a diagram explaining the details of the substrate quality training unit.

As shown in FIG. 26, the substrate quality training unit 2502 includes an input unit 2601, trained substrate quality prediction models 2602, and a comparison/change unit 2603. The substrate quality training unit 2502 performs re-training processing using training data sets 2610_1, 2610_2, ..., and 2610_n (an example of a second training data set) stored in the work information storage unit 2511.

As shown in FIG. 26, the training data sets 2610_1, 2610_2, ..., and 2610_n are stored separately per work item. In the example of FIG. 26, the training data set 2610_1 is a training data set in which the content of an operation of the work item number = 101 (chamber interior cleaning) is input data.

As shown in FIG. 26, the training data sets 2610_1, 2610_2, ..., and 2610_n include "input data" and "ground truth data" as information items. For example, in the case of the training data set 2610_1, it is assumed that the "input data" and "ground truth data" previously store the content of the operation for chamber interior cleaning performed in a past maintenance work and the accompanying substrate quality information. Then, every time maintenance work for the work item number = 101 (chamber interior cleaning) is completed, the content of the operation in the work and accompanying substrate quality information are added to the training data set 2610_1.

The input unit 2601 reads out the training data set 2610_1 when a content of an operation and substrate quality information are added to the training data set 2610_1 as a result of completion of maintenance work for the work item number = 101 (chamber interior cleaning). The "input data" of the read-out training data set 2610_1 is input into a corresponding trained substrate quality prediction model 2602.

The trained substrate quality prediction models 2602 include a number of trained substrate quality prediction models corresponding to the number of the training data sets (that is, the number of work items), and output output data when the "input data" of the training data set is input by the input unit 2601. It is assumed that the trained substrate quality prediction model 2602 has been subjected to training processing using, for example, the training data set 2610_1, which is the training data set 2610_1 before addition of a content of an operation and substrate quality information.

The comparison/change unit 2603 compares the output data output from the trained substrate quality prediction model 2602 with the work quality stored in the "ground truth data" of the training data set, and updates the model parameter of the trained substrate quality prediction model 2602 according to the error.

Thus, the substrate quality training unit 2502 performs re-training processing to generate a re-trained substrate quality prediction model (a model for predicting a substrate quality from a content of an operation) for each work item.

### <Details of Work Information Optimization Unit>

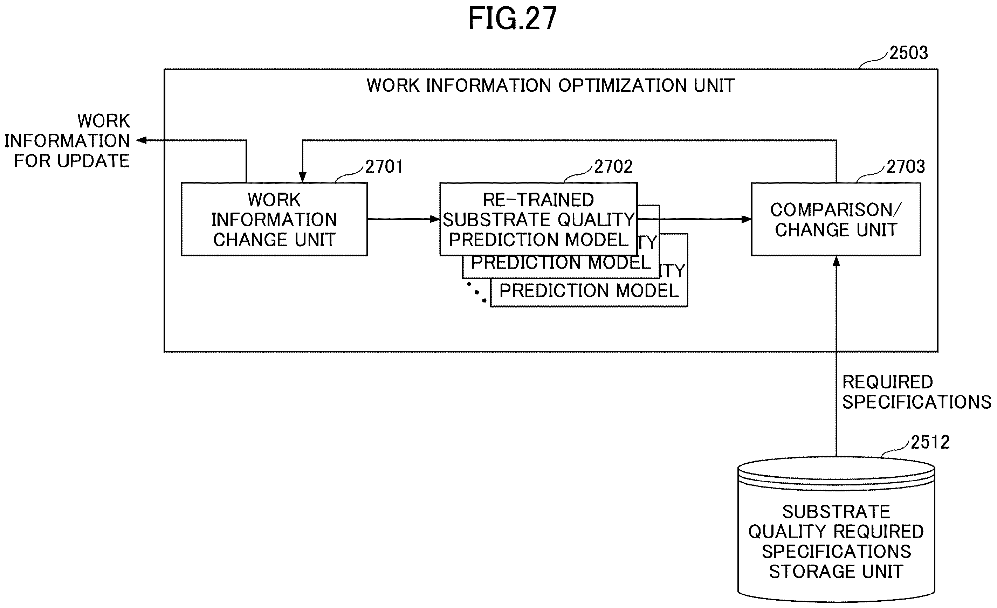

Next, details of the work information optimization unit 2503 will be described. FIG. 27 is a diagram explaining details of the work information optimization unit.

As shown in FIG. 27, the work information optimization unit 2503 includes a work information change unit 2701, re-trained substrate quality prediction models 2702, and a comparison/change unit 2703. The work information optimization unit 2503 searches for an optimal content of an operation for each work item and outputs work information for update.

When a re-trained substrate quality prediction model 2702 is newly generated, the work information change unit 2701 exhaustively changes contents of operations (contents of operations for maintenance work) for the corresponding work item and inputs the changed contents to the newly generated re-trained substrate quality prediction model 2702. The work information change unit 2701 outputs a content of an operation, in response to which a substrate quality satisfying required specifications is predicted among the contents of operations exhaustively changed for the corresponding work item.

The re-trained substrate quality prediction model 2702 is a re-trained substrate quality prediction model generated for each work item by the substrate quality training unit 2502, and predicts a substrate quality when a content of an operation is input by the work information change unit 2701.

The comparison/change unit 2703 compares the substrate quality predicted by the re-trained substrate quality prediction model 2702 with the required specifications read out from the substrate quality required specifications storage unit 2512, and determines whether or not the predicted substrate quality satisfies the required specifications. The comparison/change unit 2703 provides the predicted substrate quality together with the determination result to the work information change unit 2701 as a notification.

### <Flow of Maintenance Work Support Processing Performed by Remote Monitoring Apparatus>

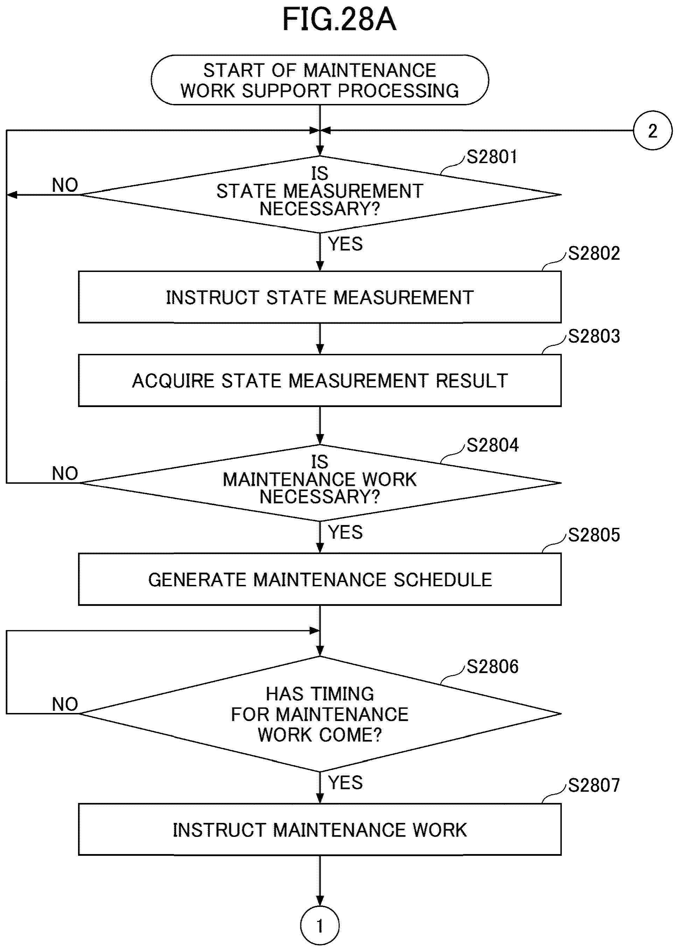

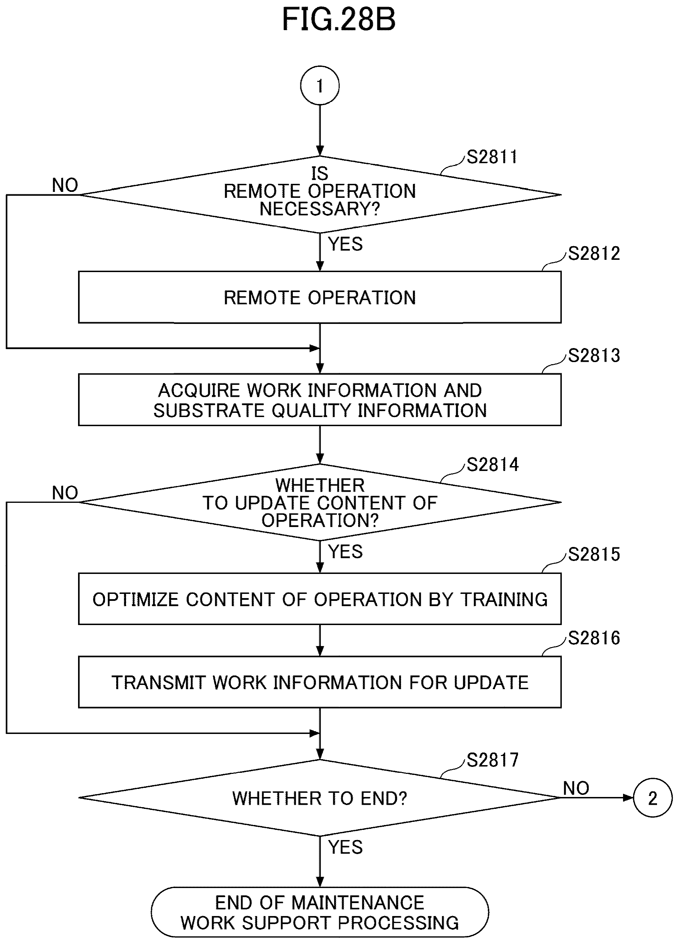

Next, a flow of the maintenance work support processing performed by the remote monitoring apparatus 210 will be described. FIGS. 28A and 28B are first and second flowcharts showing the flow of the maintenance work support processing performed by the remote monitoring apparatus. Here, the maintenance work support processing for the substrate processing system 121, which is the target system, will be described.

In step S2801 of FIG. 28A, the remote monitoring apparatus 210 determines whether or not state measurement is necessary for the substrate processing system 121, which is the target system. When it is determined in step S2801 that state measurement is not necessary (NO in step S2801), the process waits until it is determined that state measurement is necessary.

On the other hand, when it is determined in step S2801 that state measurement is necessary (YES in step S2801), the process proceeds to step S2802.

In step S2802, the remote monitoring apparatus 210 instructs the stowable work robot 240_1 stowed in the substrate processing system 121, which is the target system, to perform state measurement.

In step S2803, the remote monitoring apparatus 210 acquires a state measurement result from the stowable work robot 240_1.

In step S2804, the remote monitoring apparatus 210 determines whether or not maintenance work for the substrate processing system 121 is necessary based on the acquired state measurement result. When it is determined in step S2804 that maintenance work is not necessary (NO in step S2804), the process returns to step S2801.

On the other hand, when it is determined in step S2804 that maintenance work is necessary (YES in step S2804), the process proceeds to step S2805.

In step S2805, the remote monitoring apparatus 210 generates a maintenance schedule.

In step S2806, the remote monitoring apparatus 210 determines whether or not the timing for the maintenance work has come. When it is determined in step S2806 that the timing for the maintenance work has not come (NO in step S2806), the process waits until the timing for the maintenance work has come.

On the other hand, when it is determined in step S2806 that the timing for the maintenance work has come (YES in step S2806), the process proceeds to step S2807.

In step S2807, the remote monitoring apparatus 210 transmits a maintenance work instruction to the work robot 220, the stowable work robot 240_1, and the conveying robot 230.

In step S2811 of FIG. 28B, the remote monitoring apparatus 210 determines whether or not the work robot 220 or the stowable work robot 240_1 needs to be remotely operated. When it is determined in step S2811 that remote operation is unnecessary (NO in step S2811), the process proceeds to step S2813.

On the other hand, when it is determined in step S2811 that a remote operation is necessary (YES in step S2811), the process proceeds to step S2812.

In step S2812, the remote monitoring apparatus 210 remotely operates the work robot 220 or the stowable work robot 240_1.

In step S2813, the remote monitoring apparatus 210 acquires work information from the work robot 220 and the stowable work robot 240_1. In addition, the remote monitoring apparatus 210 acquires substrate quality information from the substrate quality inspection apparatus.

In step S2814, the remote monitoring apparatus 210 determines whether or not it is necessary to update the content of the operation of the maintenance work. When it is determined in step S2814 that it is unnecessary to update the content of the operation of the maintenance work (NO in step S2814), the process proceeds to step S2817.

On the other hand, when it is determined in step S2814 that it is necessary to update the content of the operation of the maintenance work (YES in step S2814), the process proceeds to step S2815.

In step S2815, the remote monitoring apparatus 210 re-trains the trained substrate quality prediction model using the training data set to which the acquired work information and substrate quality information are added, and generates a re-trained substrate quality prediction model. The remote monitoring apparatus 210 also optimizes the content of the operation using the generated re-trained substrate quality prediction model, and generates work information for update.

In step S2816, the remote monitoring apparatus 210 transmits the generated work information for update to the work robot 220 or the stowable work robot 240_1.

In step S2817, the remote monitoring apparatus 210 determines whether or not to end the maintenance work support processing. When it is determined in step S2817 to continue the maintenance work support processing (NO in step S2817), the process returns to step S2801.

On the other hand, when it is determined in step S2817 to end the maintenance work support processing, the maintenance work support processing is ended.

### <Summary>

As is clear from the above description, the maintenance work support system 110 according to the first embodiment includes a work robot and a stowable work robot for performing maintenance work for each work item, and the work robot and the stowable work robot are configured to:
- measure a measurement-target part specified for a target work item every time maintenance work for the work item is performed;
- determine whether or not a measurement result satisfies a work quality set for the work item; and
- when it is determined that the work quality is not satisfied, perform control to perform an additional operation for the maintenance work for the work item until it is determined that the work quality is satisfied.

Thus, according to the maintenance work support system 110 of the first embodiment, it is possible to satisfy the set work quality in all maintenance work, and to bring uniformity to the quality of the maintenance work.

Further, the maintenance work support system 110 according to the first embodiment includes a work robot and a stowable work robot for performing maintenance work for each work item, and the work robot and the stowable work robot are configured to:
- include a re-trained work quality prediction model that has been subjected to re-training processing using a training data set including a work parameter (an amount of an operation, a number of times to perform an operation, and the like) related to each operation involved in maintenance work and the work quality of the maintenance work, and
- optimize the work parameter by using the re-trained work quality prediction model.

Thus, according to the maintenance work support system 110 of the first embodiment, the work parameter satisfying the set work quality can be used in all maintenance work. As a result, according to the maintenance work support system 110 of the first embodiment, it is possible to complete the maintenance work without any additional operation, and to perform uniform-quality maintenance work efficiently.

Further, the maintenance work support system 110 according to the first embodiment includes a remote monitoring apparatus that is communicably connected to a work robot, a stowable work robot, and a conveying robot and manages each robot, and the remote monitoring apparatus is configured to:
- include a re-trained substrate quality prediction model that has been subjected to re-training processing using a training data set including a content of an operation of each robot when performing maintenance work and substrate quality information about a substrate processed at a start-up after the maintenance work; and
- optimize the content of the operation using the re-trained substrate quality prediction model.

Thus, according to the maintenance work support system 110 of the first embodiment, it is possible to operate the work robot and the stowable work robot according to the content of the operation satisfying the set substrate quality in all maintenance work. As a result, according to the maintenance work support system 110 of the first embodiment, it is possible to maintain the substrate quality achieved through the maintenance work.

### [Second Embodiment]

In the first embodiment described above, the remote monitoring apparatus 210 transmits a state measurement instruction to the stowable work robots 240_1 to 240_3 during a substrate processing period. However, the destination to which the remote monitoring apparatus 210 transmits a state measurement instruction during the substrate processing period is not limited to the stowable work robots 240_1 to 240_3.

For example, when one or a plurality of measuring instruments for measuring the state of the interior of the substrate processing systems 121 to 123 are installed in the substrate processing systems 121 to 123, the remote monitoring apparatus 210 may transmit a state measurement instruction to the substrate processing systems 121 to 123. When one or a plurality of measuring instruments for measuring the state of the interior of the substrate processing systems 121 to 123 are installed outside the substrate processing systems 121 to 123, the remote monitoring apparatus 210 may transmit a state measurement instruction to a predetermined apparatus including the one or the plurality of measuring instruments installed outside. Examples of the predetermined apparatus including the one or the plurality of measuring instruments installed outside may include the work robot 220 and the conveying robot 230.

In the first embodiment, the remote monitoring apparatus 210 has been described as the actor of transmitting a state measurement instruction. However, the actor of transmitting a state measurement instruction is not limited to the remote monitoring apparatus 210, and an apparatus, a robot, and the like other than the remote monitoring apparatus 210 may transmit a state measurement instruction to the destination described above.

For example, the work robot 220 may transmit a state measurement instruction to the stowable work robots 240_1 to 240_3, the conveying robot 230, the substrate processing systems 121 to 123, the apparatus installed outside the substrate processing systems 121 to 123, and the like. Thus, the combination of the actor of transmitting a state measurement instruction and the destination may be desirably selected.

Similarly, the combination of the actor of transmitting a state measurement result and the destination may be desirably selected. For example, a state measurement result measured by one or a plurality of measuring instruments installed in the substrate processing systems 121 to 123 may be transmitted to the work robot 220.

In the first embodiment, attaching the stowable work robot 240_1 to the robot arm 470 has been described as being performed by inserting the tip of the robot arm 470 into the connection part 790 of the stowable work robot 240_1. However, the attachment method for attaching the stowable work robot 240_1 to the robot arm 470 is not limited to this.

For example, the connection part 790 of the stowable work robot 240_1 may be attached to the robot arm 470 after the tip of the robot arm 470 is removed. In other words, the stowable work robot 240_1 may be configured to replace a part of the robot arm.

In the first embodiment, the stowable work robot 240_1 is configured to perform maintenance work or state measurement by being stowed in the stowing part 471 and attached to the robot arm 470. However, the configuration of the stowable work robot 240_1 is not limited to this, and it may be configured to, for example, travel autonomously in the substrate processing system 121.

In the first embodiment described above, chamber interior cleaning in the etching apparatus 410 has been described as being performed by the stowable work robot 240_1 (see, for example, FIG. 9B). However, each work item of the maintenance work is not necessarily performed by either of the work robot 220 and the stowable work robot 240_1, and may be performed by both robots. Here, cases where both robots perform cleaning include a case where the work robot 220 and the stowable work robot 240 perform cleaning in parallel and a case where they perform cleaning in turn.

In the first embodiment described above, when the work robot 220 accesses a processing apparatus, it is assumed that the processing apparatus is in an open-air atmospheric. However, the work robot 220 may be stored in a housing such that the work robot 220 can access the processing apparatus even if the processing apparatus is in a vacuum state. For example, the housing of the work robot 220 and the processing apparatus 431 may be connected such that the processing space 510s in the chamber 510 and the housing of the work robot 220 form a single space. In this case, the housing of the work robot 220 is connected to the pipe 543 of the processing apparatus 431, and the gas exhaust system 540 brings the interior of the housing of the work robot 220 into a vacuum state. Alternatively, a vacuum pumping mechanism is provided on the housing of the work robot 220, and the mechanism brings the interior of the housing into a vacuum state.

In the first embodiment described above, it is assumed that there is one work robot 220. However, there may be a plurality of work robots 220. For example, in the case of performing unit-by-unit replacement work instead of performing maintenance work on the interior of the substrate processing system 121, the plurality of work robots 220 may perform the replacement work based on cooperative control.

It should be noted that the present invention is not limited to the configurations shown here, such as the configurations presented in the above embodiments, combinations with other elements, and the like. These particulars may be modified within the scope that do not depart from the spirit of the present invention, and may be appropriately specified in accordance with the application form.

The present application claims priority based on Japanese Patent Application No. 2023-41601, filed on March 16, 2023, the entire contents of which are incorporated herein by reference.

### REFERENCE SIGNS LIST

110: maintenance work support system
121 to 123: substrate processing system
210: remote monitoring apparatus
220: work robot
230: conveying robot
240_1 to 240_3: stowable work robot
410: etching apparatus
421: vacuum conveying chamber
431 to 436: processing apparatus
470: robot arm
471: stowing part
510: chamber
511a: electrostatic chuck
514, 514': edge ring
703: controller
740: end effector
760: multi-sensor unit
790: connection part
791: end effector
792: multi-sensor unit
793: controller
1012: drive controller
1013: sensor
1101: main control unit
1102: sensor data processing unit
1103: cooperative control unit
1111: main control unit
1112: sensor data processing unit
1113: cooperative control unit
1120: maintenance work control unit
1121: consumables replacement control unit
1122: cleaning control unit
1123: state measurement control unit
1124: replacement work parameter
1125: cleaning work parameter
1131: sensor data processing unit
1132: work quality inspection unit
1141: work quality training unit
1142: work parameter optimization unit
1143: parameter update unit
1151: work information collection unit
1152: work information update unit
1160: maintenance work remote operation control unit
1200: work quality information
1700: main body
1704: conveying table
1706: end effector exchanger
1710: controller
2010: main control unit
2011: sensor data processing unit
2012: cooperative control unit
2300: maintenance work management unit
2310: operation device
2320: HMD
2501: work information storage control unit
2502: substrate quality training unit
2503: work information optimization unit
2504: substrate quality storage control unit
2505: remote operation unit

## Claims

1. A maintenance work support system including a work robot configured to perform maintenance work for each work item, the maintenance work support system comprising:
a measurement unit configured to measure a measurement-target part specified for a target work item every time maintenance work for the work item is performed;
a determination unit configured to determine whether or not a measurement result measured by the measurement unit satisfies a work quality set for the work item; and
a control unit configured to, when it is determined that the work quality is not satisfied, control the work robot to perform an additional operation for the maintenance work for the work item until the determination unit determines that the work quality is satisfied.

2. The maintenance work support system according to claim 1,
wherein the work robot performs the maintenance work for the work item on an interior of a processing space of a substrate processing system.

3. The maintenance work support system according to claim 2,
wherein the work robot includes:
a first work robot positioned outside the substrate processing system and configured to perform the maintenance work for the work item; and
a second work robot positioned inside the substrate processing system and configured to perform the maintenance work for the work item.

4. The maintenance work support system according to claim 3,
wherein the first work robot and the second work robot include a finger mechanism including a plurality of fingers, and
the finger mechanism is configured to change an interval between the fingers depending on the work item.

5. The maintenance work support system according to claim 3,
wherein while substrate processing is performed in the processing space of the substrate processing system, the second work robot is stowed at a predetermined position in a conveying chamber of the substrate processing system, and
after the substrate processing in the processing space of the substrate processing system is completed and while a maintenance period continues, the second work robot performs the maintenance work on the interior of the processing space of the substrate processing system by a part of a substrate conveying robot arm in the conveying chamber being replaced with the second work robot.

6. The maintenance work support system according to claim 1,
wherein a work parameter related to an operation involved in the maintenance work by the work robot is specified for each work item.

7. The maintenance work support system according to claim 6, further comprising:
a first training unit configured to perform re-training processing on a trained work quality prediction model using a first training data set including: the work parameter; and a measurement result measured by the measurement unit when the work robot performs the maintenance work for the work item under the work parameter.

8. The maintenance work support system according to claim 7, further comprising:
a first optimization unit configured to optimize the work parameter by searching for input data, in response to which a re-trained work quality prediction model subjected to the re-training processing by the first training unit outputs an output that satisfies the work quality set for the work item; and
a first update unit configured to update the work parameter specified for the work item to the work parameter optimized by the first optimization unit.

9. The maintenance work support system according to claim 3,
wherein while substrate processing is performed in the processing space of the substrate processing system, the second work robot is stowed at a predetermined position in a conveying chamber of the substrate processing system, and
after the substrate processing in the processing space of the substrate processing system is completed, the second work robot performs state measurement in the processing space of the substrate processing system by a part of a substrate conveying robot arm in the conveying chamber being replaced with the second work robot.

10. The maintenance work support system according to claim 9,
wherein the first work robot performs the maintenance work on the processing space of the substrate processing system that is determined to need the maintenance work based on a result of the state measurement by the second work robot among a plurality of substrate processing systems, each of which is the substrate processing system.

11. The maintenance work support system according to claim 10, further comprising:
a conveying robot configured to provide the first work robot with a consumable article or an end effector necessary for the maintenance work for the work item,
wherein the conveying robot provides the first work robot with a consumable article or an end effector necessary for the maintenance work for the work item that is specified for the processing space of the substrate processing system on which the first work robot performs the maintenance work among the plurality of substrate processing systems.

12. The maintenance work support system according to claim 11,
wherein the first work robot, the second work robot, the conveying robot, and the substrate processing system communicate with a management device.

13. The maintenance work support system according to claim 12,
wherein the management device is configured to:
instruct the second work robot to perform state measurement in the substrate processing system; and
determine a maintenance schedule based on a result of the state measurement transmitted from the second work robot and indicating a state in the substrate processing system.

14. The maintenance work support system according to claim 12,
wherein when a maintenance work instruction is transmitted from the management device, the first work robot identifies a processing apparatus of the substrate processing system that is a target of the maintenance work, and a work item, and
when a maintenance work instruction is transmitted from the management device, the conveying robot identifies a processing apparatus of the substrate processing system that is a target of the maintenance work, and a consumable article or an end effector that is necessary for the maintenance work.

15. The maintenance work support system according to claim 2, further comprising:
a second training unit configured to perform re-training processing on a trained substrate quality prediction model using a second training data set including: a content of an operation specified for the work item; and information related to a substrate quality achieved when substrate processing is performed in the processing space of the substrate processing system after the maintenance work for the work item is performed.

16. The maintenance work support system according to claim 15, further comprising:
a second optimization unit configured to optimize the content of the operation by searching for input data, in response to which a re-trained substrate quality prediction model subjected to the re-training processing by the second training unit outputs an output that satisfies required specifications of the substrate quality; and
a second update unit configured to update the content of the operation specified for the work item with the content of the operation optimized by the second optimization unit.

17. The maintenance work support system according to claim 16, further comprising:
a management device communicably connected to the work robot,
wherein the second training unit, the second optimization unit, and the second update unit are implemented in the management device.

18. The maintenance work support system according to claim 17,
wherein the management device further includes a remote operation unit configured to:
acquire image data captured by an imaging device mounted on the work robot, and transmit the image data to a display device used by a remote monitoring person for viewing the image data; and
acquire an operation instruction for the work robot from the remote monitoring person, and transmit the operation instruction to the work robot.

19. The maintenance work support system according to claim 2,
wherein the maintenance work includes any of replacement of a consumable article of the substrate processing system, replacement of a unit in which a consumable article has been replaced, or cleaning of an inner wall of the processing space of the substrate processing system.

20. A control method for a computer of a work robot configured to perform maintenance work for each work item to perform:
a measurement step of measuring a measurement-target part specified for a target work item every time maintenance work for the work item is performed;
a determination step of determining whether or not a measurement result measured in the measurement step satisfies a work quality set for the work item; and
a control step of, when it is determined that the work quality is not satisfied, controlling an additional operation for the maintenance work for the work item to be performed until it is determined in the determination step that the work quality is satisfied.

21. A control program for causing a computer of a work robot configured to perform maintenance work for each work item to execute:
a measurement step of measuring a measurement-target part specified for a target work item every time maintenance work for the work item is performed;
a determination step of determining whether or not a measurement result measured in the measurement step satisfies a work quality set for the work item; and
a control step of, when it is determined that the work quality is not satisfied, controlling an additional operation for the maintenance work for the work item to be performed until it is determined in the determination step that the work quality is satisfied.
